# EUROPEAN PATENT APPLICATION

(11) **EP 4 626 031 A2**
(43) Date of publication of application: **01.10.2025**
(21) Application number: 25164304.5
(22) Date of filing: 18.03.2025
(51) Int. Cl.: H04R 17/00

(54) **MEMS DEVICE AND ELECTRO-ACOUSTIC TRANSDUCER**

(30) Priority: 26.03.2024 JP 2024049452; 26.03.2024 JP 2024049449; 26.03.2024 JP 2024049455; 26.03.2024 JP 2024049446; 29.11.2024 JP 2024208751
(71) Applicant: MITSUMI ELECTRIC CO., LTD., Tama-Shi, Tokyo 206-8567 (JP)
(72) Inventor: HIGASHI, Satoru, TAMA-SHI, 206-8567 (JP); AGA, Hisanori, TAMA-SHI, 206-8567 (JP)
(74) Representative: Regimbeau

(57) **Abstract**

A MEMS device includes a frame-shaped fixed portion, a movable portion disposed inside the fixed portion in plan view, four torsion beams supporting the movable portion, a drive beam provided for each torsion beam of the four torsion beams and including a first end connected to the torsion beam and a second end connected to an inner edge of the fixed portion, and a drive source disposed for each of the drive beams. Each of the drive beams is disposed point-symmetrically with respect to a center of the movable portion in plan view. In plan view, each of the drive beams includes a region whose width in a direction parallel to a first side, of the drive beam, connected to the inner edge gradually increases toward the first side.

## Description

### BACKGROUND

### 1. Technical Field

The present disclosure relates to a MEMS (Micro Electro Mechanical Systems) device and an electro-acoustic transducer.

### 2. Description of the Related Art

MEMS (Micro Electro Mechanical Systems) devices manufactured using a microfabrication technology in MEMS have been developed. The MEMS devices are manufactured by semiconductor processes, and these devices have many advantages such as low variability, small size, thin body, light weight, low power consumption, and good frequency characteristics. A MEMS device has a fixed portion and a movable portion, and by driving the movable portion, the MEMS device can be used in an electro-acoustic transducer such as an earpiece or a microphone (see, for example, Patent Document 1).

### [Related-Art Document]

### [Patent Document]

Patent Document 1: US Patent No. 9980051

### SUMMARY

A micro electro mechanical systems (MEMS) device includes a frame-shaped fixed portion, a movable portion disposed inside the fixed portion in plan view, four torsion beams supporting the movable portion, a drive beam provided for each torsion beam of the four torsion beams and including a first end connected to the torsion beam and a second end connected to an inner edge of the fixed portion, and a drive source disposed for each of the drive beams. Each of the drive beams is disposed point-symmetrically with respect to a center of the movable portion in plan view. In plan view, each of the drive beams includes a region whose width in a direction parallel to a first side, of the drive beam, connected to the inner edge gradually increases toward the first side.

### BRIEF DESCRIPTION OF THE DRAWINGS

FIG. 1 is an upper perspective view illustrating a MEMS device according to a first embodiment.
FIG. 2 is a lower perspective view illustrating the MEMS device according to the first embodiment.
FIG. 3 is an upper view illustrating the MEMS device according to the first embodiment.
FIG. 4 is a lower view illustrating the MEMS device according to the first embodiment.
FIG. 5 is a cross-sectional view illustrating the MEMS device according to the first embodiment.
FIG. 6 is a diagram (part 1) for describing stress reduction in a MEMS device 20.
FIG. 7 is a diagram illustrating the effect of a structure shown in FIG. 6.
FIG. 8 is a diagram (part 2) for describing the stress reduction in the MEMS device 20.
FIG. 9 is a diagram (part 3) for describing the stress reduction in the MEMS device 20.
FIG. 10 is a diagram (part 4) for describing the stress reduction in the MEMS device 20.
FIG. 11 is a simulation result of a resonance frequency in the MEMS device 20.
FIG. 12 is an upper perspective view illustrating an electro-acoustic transducer according to the first embodiment.
FIG. 13 is a lower perspective view illustrating an electro-acoustic transducer according to the first embodiment.
FIG. 14 is a cross-sectional view illustrating the electro-acoustic transducer according to the first embodiment.
FIG. 15 is an upper exploded perspective view illustrating the electro-acoustic transducer according to the first embodiment.
FIG. 16 is a lower exploded perspective view illustrating the electro-acoustic transducer according to the first embodiment.
FIG. 17 is a diagram (part 1) for describing a method of manufacturing the electro-acoustic transducer according to the first embodiment.
FIG. 18 is a diagram (part 2) for describing the method of manufacturing the electro-acoustic transducer according to the first embodiment.
FIG. 19 is an upper view illustrating the MEMS device according to a second embodiment.
FIG. 20 is a diagram illustrating a comparison result between a MEMS device 20A and the MEMS device 20.
FIG. 21 is an upper exploded perspective view illustrating the electro-acoustic transducer according to a third embodiment.
FIG. 22 is a diagram illustrating a simulation result of resonant frequencies in the MEMS device and a membrane.
FIG. 23 is a diagram illustrating a simulation result of the resonance frequency when changing thicknesses of a torsion beam and a drive beam.
FIG. 24 is an upper exploded perspective view illustrating the electro-acoustic transducer according to a fourth embodiment.
FIG. 25 is an upper view illustrating a substrate constituting the electro-acoustic transducer according to the fourth embodiment.
FIG. 26 is an upper view illustrating a step of disposing the MEMS device on the substrate.
FIG. 27 is a cross-sectional view illustrating a step of disposing the MEMS device on the substrate.
FIG. 28 is an upper view illustrating the substrate constituting the electro-acoustic transducer in a first modification of the fourth embodiment.
FIG. 29 is an upper view illustrating a substrate constituting the electro-acoustic transducer in a second modification of the fourth embodiment.
FIG. 30 is an upper view illustrating a substrate constituting the electro-acoustic transducer in a third modification of the fourth embodiment.
FIG. 31 is an upper view illustrating positioning of the MEMS device on the substrate.
FIG. 32 is a lower view illustrating wirings in the MEMS device according to a fifth embodiment.
FIG. 33 is a diagram illustrating a simulation result of stress distribution when moving the movable portion of the MEMS device.
FIG. 34 is a lower view illustrating wirings in the MEMS device in a first modification of the fifth embodiment.
FIG. 35 is a lower view illustrating a metal film in the MEMS device according to a sixth embodiment.
FIG. 36 is a lower view illustrating an electro-acoustic transducer 1C using a MEMS device 20C.
FIG. 37 is a measurement flow of displacement of the movable portion.
FIG. 38 is a lower view illustrating the metal film in the MEMS device in a first modification of the sixth embodiment.
FIG. 39 is a lower view illustrating the metal film in the MEMS device in a second modification of the sixth embodiment.
FIG. 40 is a cross-sectional view illustrating the electro-acoustic transducer according to a seventh embodiment.
FIG. 41 is an upper view illustrating a membrane 30D.
FIG. 42 is a partial cross-sectional view illustrating the electro-acoustic transducer in a first modification of the seventh embodiment.
FIG. 43 is a partial cross-sectional view illustrating the electro-acoustic transducer in a second modification of the seventh embodiment.

### DETAILED DESCRIPTION

Hereinafter, various embodiments of the present disclosure will be described with reference to the drawings. In each of the drawings, the same components are denoted by the same numerals, and duplicate description may be omitted.

### <First Embodiment>

### (MEMS Device)

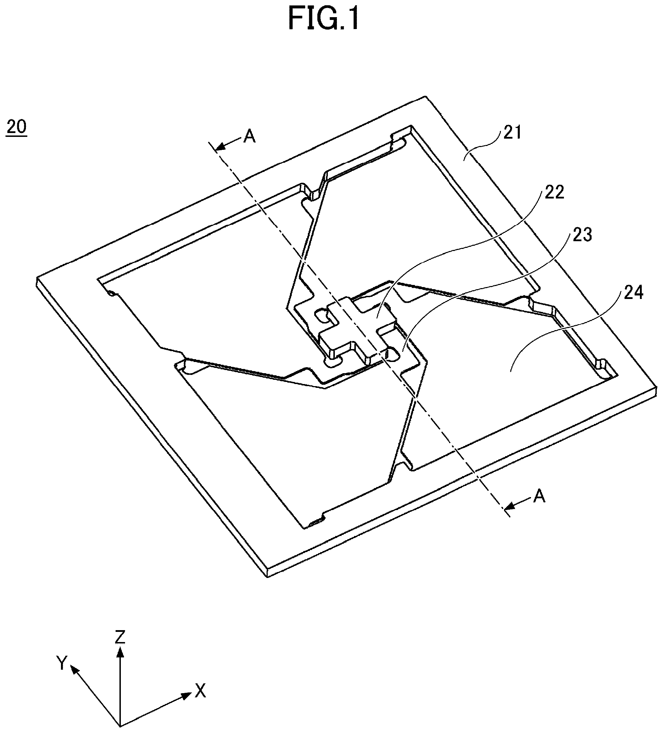

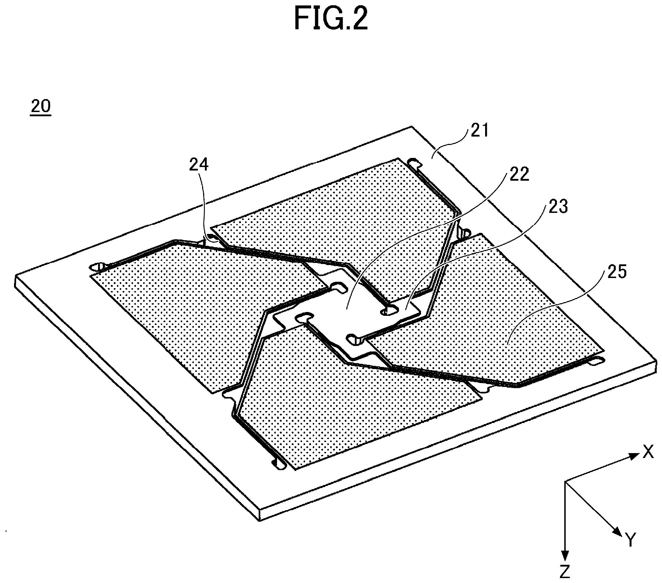

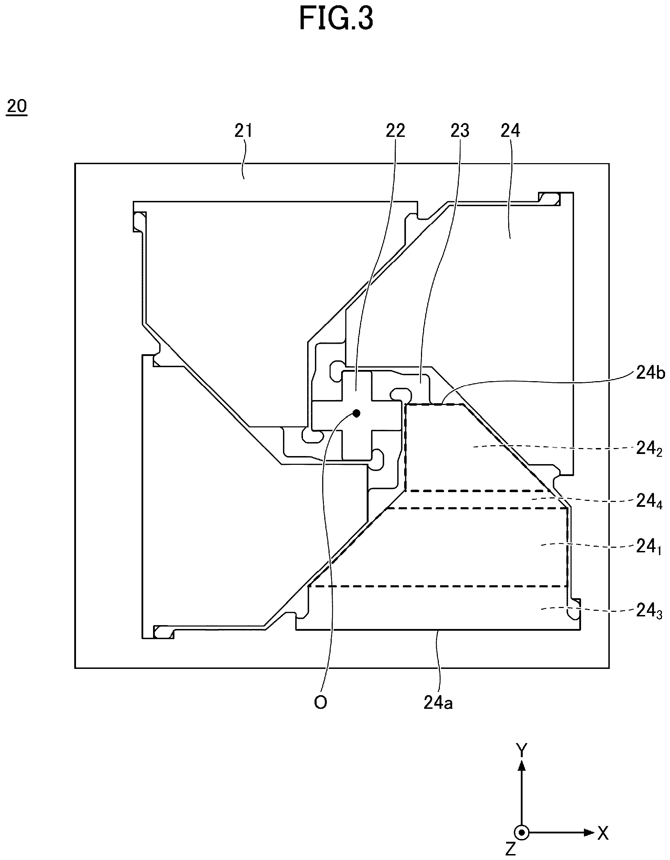

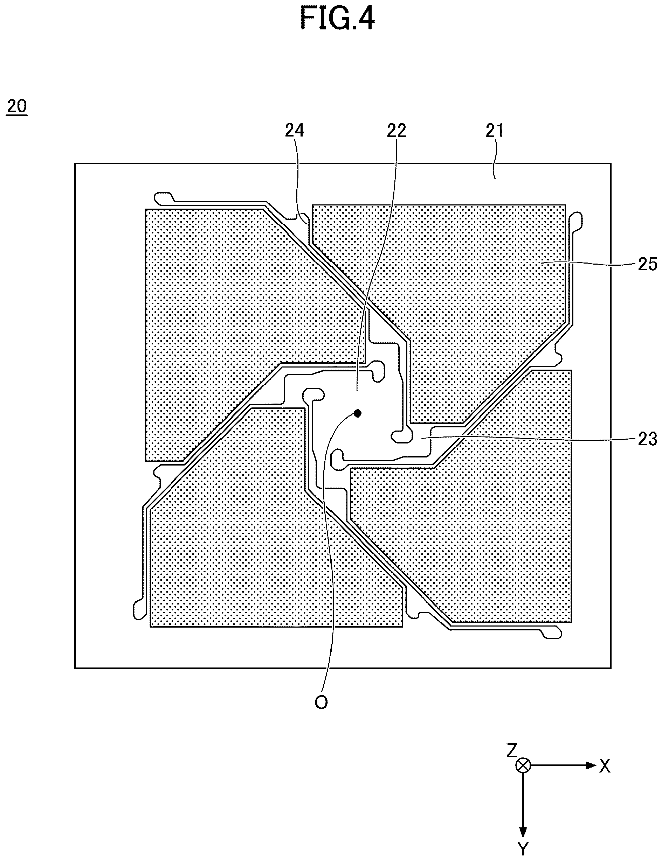

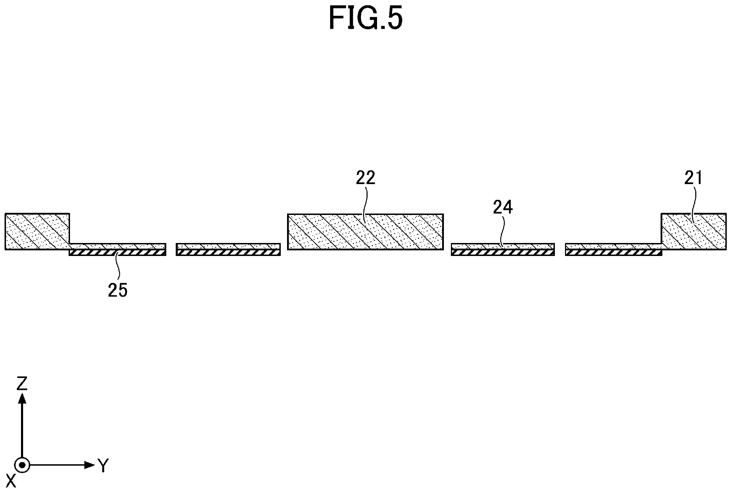

FIG. 1 is an upper side perspective view illustrating a MEMS device according to a first embodiment. FIG. 2 is a lower perspective view illustrating the MEMS device according to the first embodiment. FIG. 3 is an upper view illustrating the MEMS device according to the first embodiment. FIG. 4 is a lower view illustrating the MEMS device according to the first embodiment. FIG. 5 is a cross-sectional view illustrating the MEMS device according to the first embodiment, and illustrates a cross section taken along the line A-A in FIG. 1.

In each of the drawings, orthogonal coordinates defined using X, Y, and Z axes may be shown for a reference. In each of X, Y and Z directions, a side indicated by an arrow may be referred to as a "+ side," and its opposite side may be referred to as a "- side." In addition, a Z+ side surface of each component may be referred to as an upper surface, and a Z- side surface may be referred to as a lower surface. However, these are not intended to limit the orientation during use of the MEMS device or the like according to the embodiments, and any orientation of the MEMS device or the like according to the embodiments is used. In addition, viewing a target from the Z+ side to the Z- side, or viewing the target from the Z- side to the Z+ side may be referred to as a plane view.

Referring to FIGS. 1 to 5, a MEMS device 20 has a fixed portion 21, a movable portion 22, a plurality of torsion beams 23, a plurality of drive beams 24, and a plurality of drive sources 25. The number of torsion beams 23, drive beams 24, and drive sources 25 is the same. In FIGS. 2 and 4, each drive source 25 is indicated by a dot pattern for convenience. The same indication as the dot pattern may be used in the figures discussed below.

The fixed portion 21 is formed in a frame shape in plan view. The fixed portion 21 has an outer edge and an inner edge in plan view. The inner edge and the outer edge may or may not have a similar shape. For example, the inner edge may be polygonal and the outer edge may be circular or elliptical. In the examples of FIGS. 1 to 5, the inner edge of the fixed portion 21 is square and the outer edge is square or rectangular. When the outer edge is square or rectangular, it is advantageous in terms of reducing processing costs because the outer edge can be easily processed by blade dicing.

The length of one side of the outer edge of the fixed portion 21 can be, for example, about 3 mm to 10 mm. The width of the fixed portion 21 (distance from the inner edge to the outer edge) can be, for example, about 0.3 mm to 1.0 mm. The thickness of the fixed portion 21 can be, for example, about 100 µm to 500 µm.

In this description, for a polygon such as a square, a case where corners of the polygon are processed with rounding or chamfering, or where a projection or groove is partially provided, is also included in the category of polygons.

The movable portion 22 is disposed inside the fixed portion 21 in plan view, and is supported movably with respect to the fixed portion 21. In plan view, a center O of the movable portion 22 preferably coincides with the center of the inner edge of the fixed portion 21. In plan view, the movable portion 22 preferably has point symmetry with respect to the center O of the movable portion 22. The thickness of the movable portion 22 is the same as that of the fixed portion 21. The upper surface of the movable portion 22 is in the same plane as the upper surface of the fixed portion 21. The lower surface of the movable portion 22 is in the same plane as the lower surface of the fixed portion 21.

A structure may be such that the upper and lower surfaces of the movable portion 22 are not in the same planes as the upper and lower surfaces of the fixed portion 21. For example, the structure can be configured to offset the height of the movable portion 22 toward the upper surface with respect to the fixed portion 21, by warping the drive beam 24 through intentional changes or the like in a film formation condition or a polarization condition of the drive source 25. A distance between the upper surface of the fixed portion 21 and the upper surface of the movable portion 22 may be, for example, about 20 µm to 100 µm. A distance between the lower surface of the fixed portion 21 and the lower surface of the movable portion 22 may be, for example, about 20 µm to 100 µm.

In this description, the "same plane" refers to a state where the height difference between the two is 20 µm or less.

In plan view, the movable portion 22 has the same number of extending portions as torsion beams 23, and each extending portion extends radially from a center of the movable portion 22. Each extending portion includes an upper surface, a lower surface, an end surface, and two side surfaces connected to the end surface. In the example of FIGS. 1 to 5, the movable portion 22 has a cross shape having four extending portions that extend radially from the center in plan view.

In the movable portion 22 having the cross shape, among surfaces other than the upper surface and the lower surface, two sets of opposing surfaces in a longitudinal direction are referred to as end surfaces, and the remaining surfaces are referred to as side surfaces. In other words, when the movable portion 22 has the cross shape, the movable portion 22 has four end surfaces having the same area, and eight side surfaces having the same area. The eight side surfaces include four sets each of which includes two adjacent side surfaces. Rounded corners, chamfers, or the like that are located between end surfaces and side surfaces, and between side surfaces, are not included in the end surfaces or side surfaces.

The torsion beam 23 and the drive beam 24 connect the fixed portion 21 and the movable portion 22 at positions closer to their lower surfaces than their upper surfaces. A plurality of torsion beams 23 support the movable portion 22 from the outside. Each torsion beam 23 is capable of elastic deformation. The torsion beam 23 is thinner than the movable portion 22. The thickness of the torsion beam 23 can be, for example, about 5 µm to 60 µm. The torsion beams 23 are connected to the lower end of the side surface of the movable portion 22. In the examples of FIGS. 1 to 5, four torsion beams 23 are provided. Each torsion beam 23 is preferably arranged point-symmetrically with respect to the center O of the movable portion 22 in plan view.

The upper surface of each torsion beam 23 is positioned lower than the upper surfaces of the fixed portion 21 and the movable portion 22. The lower surface of each torsion beam 23 is in the same plane as the lower surfaces of the fixed portion 21 and the movable portion 22. In plan view, each torsion beam 23 includes, for example, an L-shaped region. When the torsion beam 23 includes an L-shaped region, the length of the torsion beam 23 can be increased. In this arrangement, the torsion beam 23 becomes more easily twisted, and the displacement of the movable portion 22 can be increased. As a result, high sound pressure can be obtained when the MEMS device 20 is used in the electro-acoustic transducer.

When the movable portion 22 has a cross shape in plan view, the length of the torsion beam 23 can be increased, compared to a case where the movable portion 22 has a square with sides having the same length as a longitudinal length of the cross. In this arrangement, the displacement of the movable portion 22 can be increased. As a result, high sound pressure can be obtained when the MEMS device 20 is used in the electro-acoustic transducer. Also, when the movable portion 22 has the cross shape in plan view, the weight can be reduced, compared to the case where the movable portion 22 has the square with sides having the same length as the longitudinal length of the cross, and thus a higher resonance frequency can be obtained.

One drive beam of the plurality of drive beams 24 is provided for each torsion beam 23. In the examples of FIGS. 1 to 5, the four torsion beams 23 are provided, and as a result, four drive beams 24 are also provided. One end of the drive beam 24 is connected to the torsion beam 23, and the other end is connected to an inner edge of the fixed portion 21. More specifically, the drive beam 24 is connected to a lower side end of the inner surface of the fixed portion 21. Each drive beam 24 is connected to only one of the four sides that constitute the inner edge of the fixed portion 21 in plan view. The number of torsion beams 23 and the number of drive beams 24 may be other than four.

Each drive beam 24 can elastically deform. The thickness of the drive beam 24 is the same as that of the torsion beam 23. The upper surface of the drive beam 24 is located lower than the upper surfaces of the fixed portion 21 and the movable portion 22. The lower surface of the drive beam 24 is in the same plane as the lower surfaces of the fixed portion 21 and the movable portion 22. The upper surface of the drive beam 24 is in the same plane as the upper surface of the torsion beam 23. The lower surface of the drive beam 24 is in the same plane as the lower surface of the torsion beam 23. Each drive beam 24 is preferably arranged point-symmetrically with respect to the center O of the movable portion 22 in plan view.

The drive source 25 is arranged on the lower surface of each of the drive beams 24. The drive source 25 is preferably disposed on substantially the entire lower surface of each drive beam 24, from the viewpoint of increasing a driving force. The drive source 25 has, for example, a piezoelectric film including a piezoelectric material that converts applied electrical energy into mechanical energy. The drive source 25 vibrates in response to the input of an AC signal.

The drive source 25 may include, for example, a lower electrode disposed on the lower surface of the drive beam 24, a piezoelectric film laminated on the lower electrode, and an upper electrode laminated on the piezoelectric film. The upper electrode and the lower electrode may be made of, for example, gold (Au), platinum (Pt), or the like. The upper electrode and the lower electrode may have a structure in which a plurality of films are laminated.

The piezoelectric film may be made of, for example, PZT (lead zirconate titanate), which is a piezoelectric material. The piezoelectric film may be made of PNZT (lead zirconate titanate niobate), PLZT (lead lanthanum zirconate titanate), PLT (lead lanthanum titanate), PMN (lead magnesiate niobate), PMNN (lead manganate niobate), BaTiO₃ (barium titanate), or the like.

The drive source 25 is not limited to a three-layer structure of the lower electrode, the piezoelectric film, and the upper electrode. The drive source 25 may have, for example, two or more layers of piezoelectric films, and one or more intermediate electrodes. In this case, the piezoelectric films and the intermediate electrodes are alternately laminated on the lower electrode in required numbers, and finally, a piezoelectric film and an upper electrode are sequentially laminated on the uppermost intermediate electrode. One or more intermediate electrodes can be made of the same material as the upper electrode and the lower electrode.

When the drive source 25 has a piezoelectric film and an intermediate electrode, the intermediate electrode is connected to ground, and a drive signal is supplied to the lower electrode and the upper electrode. When the drive signal is supplied to the lower electrode and the upper electrode, the drive source 25 is displaced according to a voltage of the drive signal. Similar driving can be achieved when the drive signal is supplied to the intermediate electrode, and the lower electrode and the upper electrode are connected to ground. By setting the number of piezoelectric films to a number n, the drive voltage of the drive source 25 can be 1/n of that in a case where the piezoelectric film has one layer.

The MEMS device 20 can be manufactured by a semiconductor process using, for example, an SOI (Silicon On Insulator) substrate. However, the MEMS device 20 is not limited to the SOI substrate, and may be configured from an Si (silicon) substrate, a sapphire substrate, an alumina substrate, a spinel substrate, a quartz substrate, a glass substrate, or a ceramic substrate. Among these substrates, the SOI substrate or the Si substrate is preferable from the viewpoint of facilitating microfabrication or the like.

The SOI substrate is a substrate in which a buried oxide (BOX) layer made of silicon oxide is provided on a support layer, which is made of single-crystal silicon (Si) and in which an active layer made of single-crystal silicon is further provided on the buried layer. When the MEMS device 20 is fabricated from the SOI substrate, the fixed portion 21 and the movable portion 22 can be formed of, for example, the support layer, the buried layer, and the active layer. The torsion beams 23 and the drive beams 24 can be formed of, for example, the active layer. Since the active layer is thin, the torsion beams 23 and the drive beams 24 formed of the active layer have elasticity.

As shown in FIG. 3, in plan view, each drive beam 24 has a region where the width in a direction parallel to a first side 24a connected to the inner edge of the fixed portion 21 gradually increases toward the first side 24a. In an example of FIG. 3, in the plan view, each drive beam 24 has a maximum width in the direction parallel to the first side 24a at a position of the first side 24a.

In the example of FIG. 3, in the plan view, each drive beam 24 has a minimum width in the direction parallel to the first side 24a at a position of a second side 24b connected to the torsion beam 23. In the example of FIG. 3, the first side 24a and the second side 24b are parallel to each other.

As shown in FIG. 3, in the plan view, each drive beam 24 may include a trapezoidal first region 24₁ and a trapezoidal second region 24₂ having a smaller area than the first region 24₁. The first region 24₁ is located on a side closer to the first side 24a, and the second region 24₂ is located on a side farther from the first side 24a than the first region 24₁. In the trapezoids constituting the first region 24₁ and the second region 24₂, the length of a lower base of the trapezoid that constitutes the second region 24₂ is equal to or less than the length of an upper base of the trapezoid that constitutes the first region 24₁, when a side near the first side 24a is defined as the lower base and a side far from the first side 24a is defined as the upper base. In the plan view, the first side 24a, the upper base of the trapezoid constituting the first region 24₁, and the upper base of the trapezoid constituting the second region 24₂ may be parallel to one another.

In the example of FIG. 3, in the plan view, one lateral side of the trapezoid constituting the first region 24₁, and one lateral side of the trapezoid constituting the second region 24₂ are perpendicular to the first side 24a. In the plan view, the other lateral side of the trapezoid constituting the first region 24₁, and the other lateral side of the trapezoid constituting the second region 24₂ have different inclination directions with respect to the first side 24a.

In other words, the other lateral side of the trapezoid constituting the first region 24₁ is inclined so as to approach the first side 24a as the first side 24a moves away from a corner of the fixed portion 21. Also, the other lateral side of the trapezoid constituting the second region 24₂ is inclined so as to move away from the first side 24a as the first side 24a moves away from the corner of the fixed portion 21.

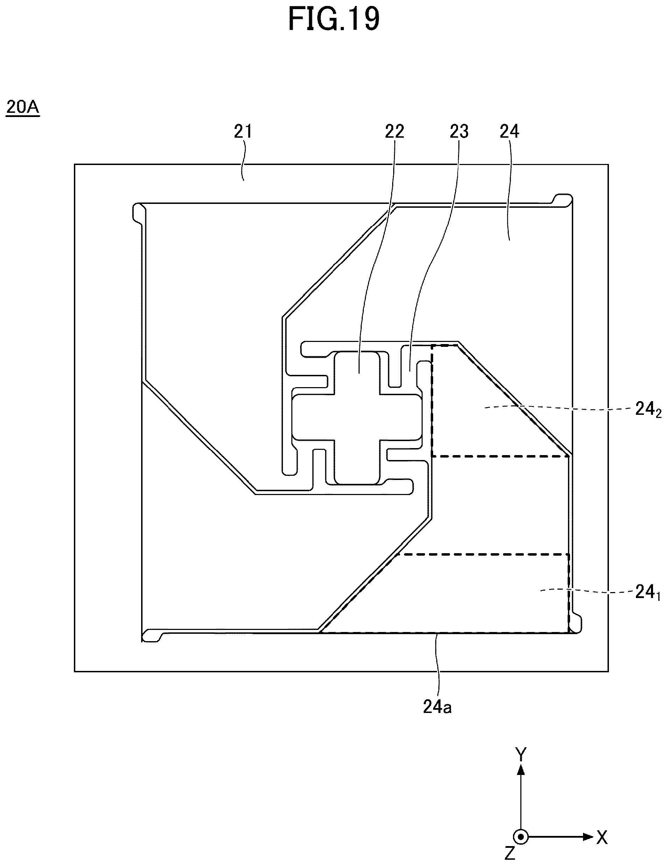

In the example of FIG. 3, in the plan view, the upper base of the trapezoid constituting the second region 24₂ is connected to the torsion beam 23, while one lateral side or the other lateral side of the trapezoid constituting the second region 24₂ may be connected to the torsion beam 23. Details will be described later with reference to FIG. 19.

In the plan view, a third region 24₃ having a rectangular shape or the like may be provided between the first side 24a and the first region 24₁, and a fourth region 24₄ having a trapezoid shape or the like may be provided between the first region 24₁ and the second region 24₂. The lower base of the trapezoid constituting the first region 24₁ may coincide with the first side 24a without the third region 24₃. In addition, the upper base of the trapezoid constituting the first region 24₁ may coincide with the lower base of the trapezoid constituting the second region 24₂, without the fourth region 24₄.

In this arrangement, in the MEMS device 20, in the plan view, each of the drive beams 24 has a region whose width in a direction parallel to the first side 24a connected to the inner edge of the fixed portion 21 gradually increases toward the first side 24a. With such a structure, a wider portion of the drive beam 24 connected to the inner edge of the fixed portion 21 can be formed, and thus the movable portion 22 can be moved with high torque and large displacement. As a result, high sound pressure can be obtained when the MEMS device 20 is used in an electro-acoustic transducer. Specifically, as described above, for example, by configuring each drive beam 24 to have a shape including the trapezoidal first region 24₁ and second region 24₂, the movable portion 22 can be moved with high torque and large displacement.

Further, in the MEMS device 20, it is preferable that the drive beam 24 is formed of single-crystal silicon, and that all of the inner and outer edges of the fixed portion 21 are parallel to [100] crystal orientation of the single-crystal silicon. As a result, higher sound pressure can be obtained when the MEMS device 20 is used in the electro-acoustic transducer. This will be described in detail below.

For example, when a substrate (wafer) formed of single-crystal silicon is used in manufacturing the MEMS device 20, a main surface of the substrate is defined as a

(100) plane. At this time, while either [110] orientation or [100] orientation is mainly used as the crystal orientation along the main surface of the substrate, a plurality of MEMS devices 20 are laid out on the substrate such that portions that become the outer and inner edges of the fixed portion 21 are parallel to the [100] orientation. In this arrangement, in the MEMS device 20 after singulation, all of the outer and inner edges of the fixed portion 21 are parallel to the [100] orientation.

The Young's modulus of single-crystal silicon varies depending on the crystal orientation. Specifically, the Young's modulus of the single-crystal silicon is about 160 GPa when the crystal orientation of the single-crystal silicon is the [110] orientation, and the above Young's modulus is about 130 GPa when the crystal orientation of the single-crystal silicon is the [100] orientation. In other words, in the MEMS device 20, when all of the outer and inner edges of the fixed portion 21 are parallel to the [100] orientation, the drive beam 24 becomes more flexible compared to when all of the outer and inner edges of the fixed portion 21 are parallel to the [110] orientation. As a result, since the movable portion 22 can move with even higher torque and larger displacement, and thus even higher sound pressure can be obtained when the MEMS device 20 is used in the electro-acoustic transducer.

When an SOI substrate is used to manufacture the MEMS device 20, main surfaces of the support layer made of single-crystal silicon and the active layer made of single-crystal silicon may be set as the (100) plane, and all of the outer and inner edges of the fixed portion 21 are parallel to the [100] orientation. In this arrangement, effects similar to those described above can be obtained.

In the MEMS device 20, all drive beams 24 have identical shapes and are arranged point-symmetrically with respect to the center of the movable portion 22 in plan view. This makes the movable portion 22 less likely to tilt when the movable portion 22 is moved, thereby reducing the possibility of unnecessary resonance.

### (Stress Reduction in MEMS Device 20)

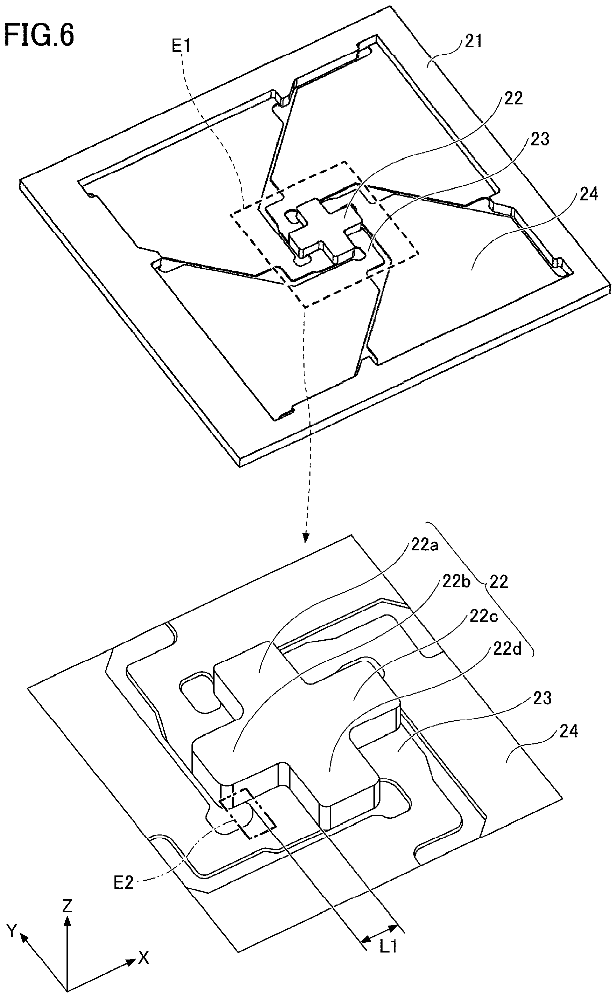

FIG. 6 is a diagram (part 1) for describing stress reduction in the MEMS device 20. The upper part of FIG. 6 is an upper perspective view of the MEMS device 20, and the lower part is an enlarged view inside an upper dashed line E1.

In an example of FIG. 6, the movable portion 22 has, in plan view, extending portions 22a, 22b, 22c, and 22d that extend radially from the center, and have a cross shape that is point symmetric about the center of the movable portion 22. As shown in FIG. 6, each torsion beam 23 is preferably connected to two adjacent sides included in different extending portions that constitute part of the movable portion 22. In the example of FIG. 6, in plan view, each torsion beam 23 is connected to an entirety of one of adjacent side surfaces and a part of the other side surface. Also, in the plan view, a corner of a portion E2 connected to the other adjacent side surface of each torsion beam 23 is rounded.

In this arrangement, each torsion beam 23 is connected to two adjacent side surfaces, and an end portion of an L-shape of each torsion beam 23 is offset by L1 with respect to one of the adjacent side surfaces of the movable portion 22. When the length of the side surface of the movable portion 22 is 400 µm, for example, L1 can be about 50 µm to 300 µm.

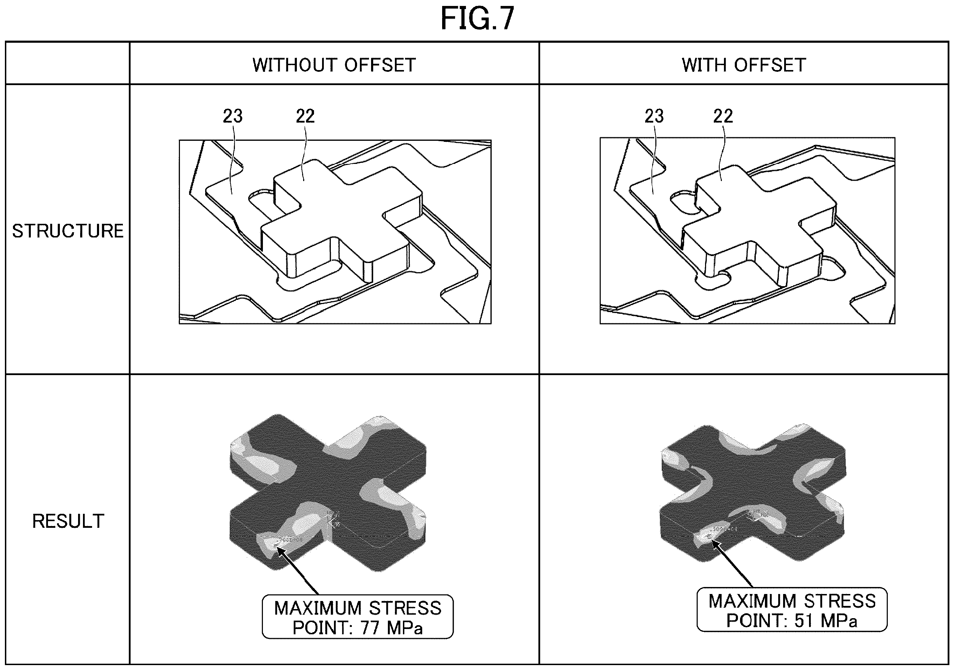

FIG. 7 is a diagram showing the effect of the structure shown in FIG. 6. In FIG. 7, a case without offset is when each torsion beam 23 is connected to only one of the adjacent side surfaces of the movable portion 22 and L1 shown in FIG. 6 is zero. A case with offset is the structure shown in FIG. 6. In FIG. 7, the result section shows contour plots of simulated stress generated when moving the movable portion 22. An arrow in the result section indicates a location of maximum stress and a value of the maximum stress. However, the figure shown in the result is vertically inverted with respect to the figure in the structure. In other words, the figure in the result shows the stress near the boundary between the torsion beam 23 and the movable portion 22.

As shown in FIG. 7, when the movable portion 22 is moved, a large stress occurs near the boundary between the torsion beam 23 and the movable portion 22. However, by providing an offset at a connection point between each torsion beam 23 and the movable portion 22, a starting point of bending of the torsion beam 23 is shifted from the side surface of the movable portion 22 at the boundary with the torsion beam 23, and thus the maximum stress can be reduced. As a result, the possibility of breakage of the torsion beam 23 can be reduced.

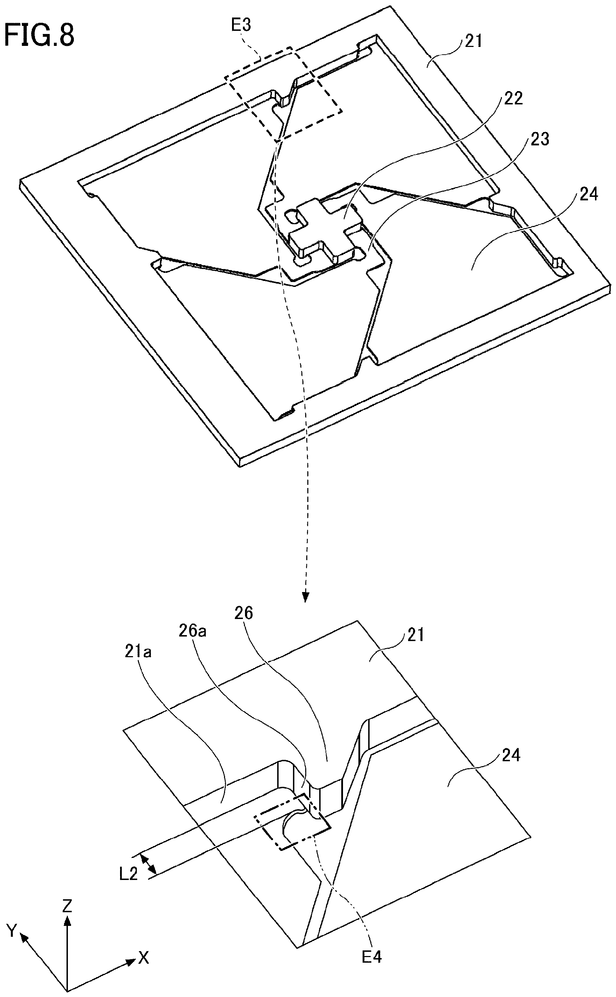

FIG. 8 is a diagram (part 2) for describing the stress reduction in the MEMS device 20. The upper part of FIG. 8 is an upper perspective view of the MEMS device 20, and the lower part is an enlarged view inside an upper dashed line E3.

As shown in FIG. 8, the MEMS device 20 has a protrusion 26 extending from sides of an inner surface 21a of the fixed portion 21 toward the movable portion 22 in plan view. The protrusion 26 has the same thickness as the fixed portion 21. The protrusion 26 has, for example, a substantially right-angled triangular shape in plan view.

Each drive beam 24 is connected to the inner surface 21a of the fixed portion 21 and a side surface 26a of the protrusion 26 that is continuous with the inner surface 21a. In plan view, a corner of a portion E4 of each drive beam 24 that is connected to the side surface 26a of the protrusion 26 is rounded.

In this arrangement, each drive beam 24 is connected to the inner surface 21a of the fixed portion 21 and the side surface 26a of the protrusion 26 that is continuous with the inner surface 21a, and thus a structure is such that one end of the connection portion of each drive beam 24 is offset with respect to the fixed portion 21 by L2 from the inner surface 21a of the fixed portion 21. When the length of the side surface 26a of the protrusion 26 is 200 µm, for example, L2 can be about 50 µm to 150 µm. By providing such an offset, the starting point of the drive beam 24 bending is shifted from the inner surface 21a of the fixed portion 21 at the boundary between the drive beam 24 and the fixed portion 21, and thus the maximum stress generated at one end side of the connection portion between the drive beam 24 and the fixed portion 21 can be reduced. As a result, the possibility of breakage of the drive beam 24 can be reduced.

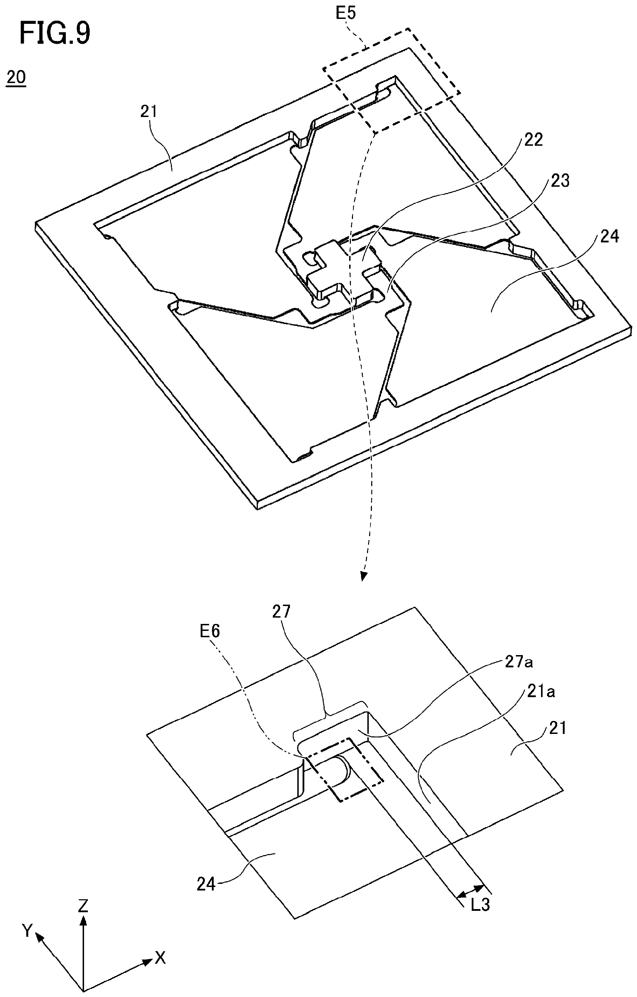

FIG. 9 is a diagram (part 3) for describing the stress reduction in the MEMS device 20. The upper part of FIG. 9 is an upper perspective view of the MEMS device 20, and the lower part is an enlarged view of the inside of an upper dashed line E5.

As shown in FIG. 9, the MEMS device 20 has a recess 27 that is recessed from each side of the inner surface 21a of the fixed portion 21 toward the outer surface in plan view. Further, each drive beam 24 is connected to the inner surface 21a of the fixed portion 21 and an inner surface 27a of the recess 27 that is continuous with the inner surface 21a. In plan view, in each drive beam 24, a corner of a portion E6 connected to the inner surface 27a of the recess 27 is rounded.

In this arrangement, each drive beam 24 is connected to the inner surface 21a of the fixed portion 21 and the inner surface 27a of the recess 27 that is continuous with the inner surface 21a, and thus a structure is such that the other end of the connection portion of each drive beam 24 with the fixed portion 21 is offset by L3 from the inner surface 21a of the fixed portion 21. when the length of the inner surface 27a of the recess 27 is 400 µm, for example, L3 can be about 50 µm to 300 µm. By providing such an offset, the starting point of the drive beam 24 bending is shifted from the inner surface 21a of the fixed portion 21 at the boundary between the drive beam 24 and the fixed portion 21, and thus the maximum stress generated at the other end side of the connection portion between the drive beam 24 and the fixed portion 21 can be reduced. As a result, the possibility of breakage of the drive beam 24 can be reduced.

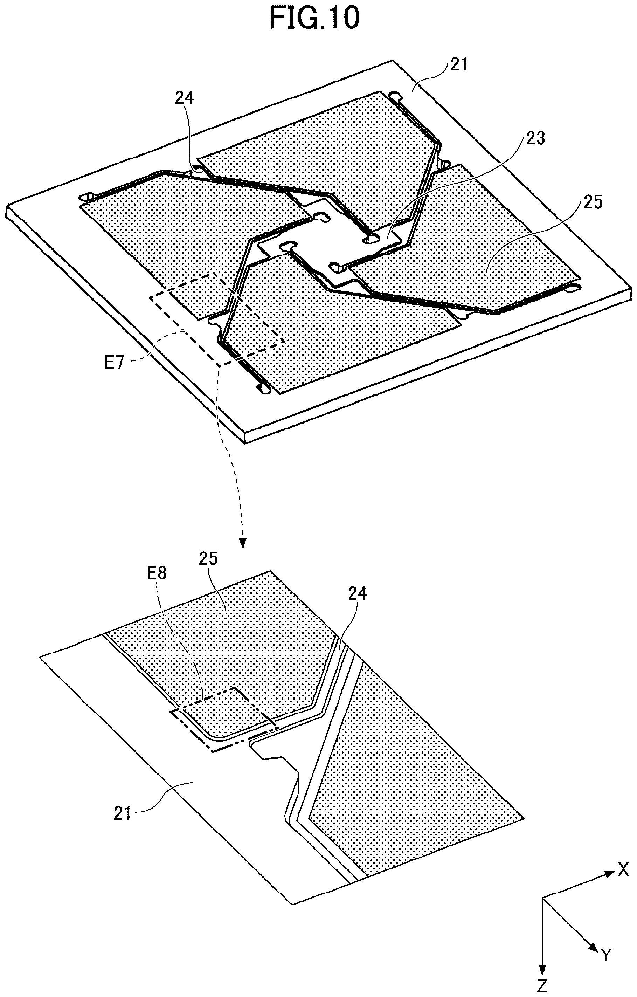

FIG. 10 is a diagram (part 4) for describing the stress reduction in the MEMS device 20. The upper part of FIG. 10 is a lower perspective view of the MEMS device 20, and the lower part is an enlarged view of the inside of an upper dashed line E7.

As shown in FIG. 10, in the MEMS device 20, a corner E8 of the drive source 25 is rounded in plan view. In this arrangement, the possibility of breakage of the drive source 25 due to electric field concentration can be reduced.

### (Size of Movable Portion 22 in MEMS Device 20)

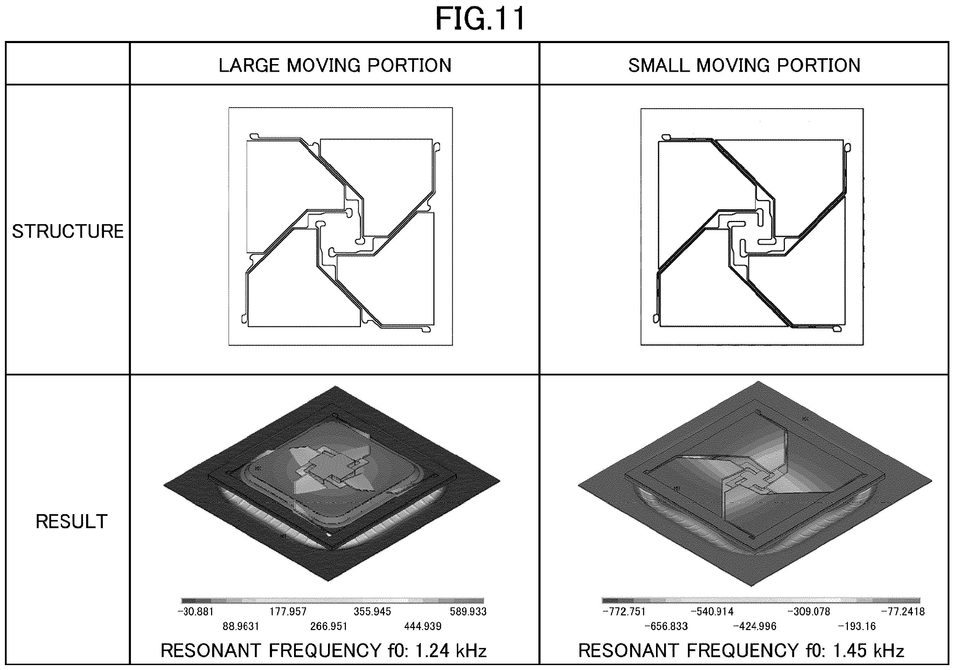

FIG. 11 is a simulation result of the resonance frequency of the MEMS device 20. In FIG. 11, a large movable portion refers to a case where the movable portion 22 has a relatively large shape, and a small movable portion refers to a case where the movable portion 22 has a relatively small shape. As shown in FIG. 11, the resonance frequency can be adjusted by changing the size of the movable portion 22. Specifically, the resonance frequency can be increased by reducing the size of the movable portion 22. In consideration of the Harman curve, the resonance frequency of the movable portion 22 is preferably from 1 kHz to 3 kHz, and more preferably around 2 kHz. The Harman curve refers to a frequency characteristic of a sound pressure level, and is used as a reference for adjusting the characteristics of a device such as a headphone.

### (Electro-Acoustic Transducer)

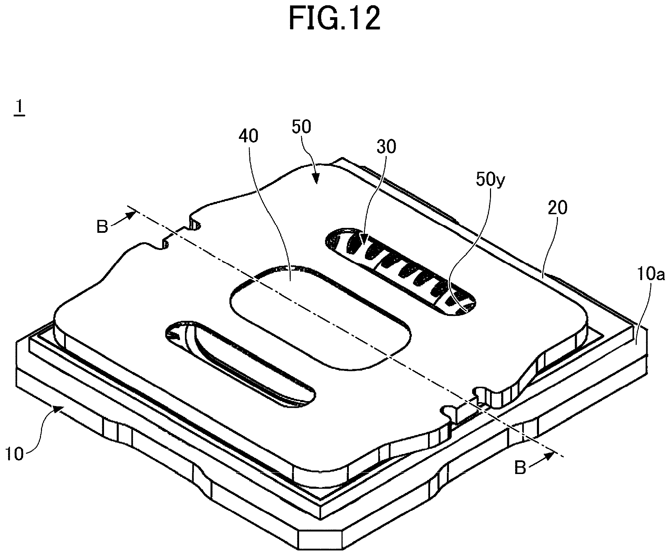

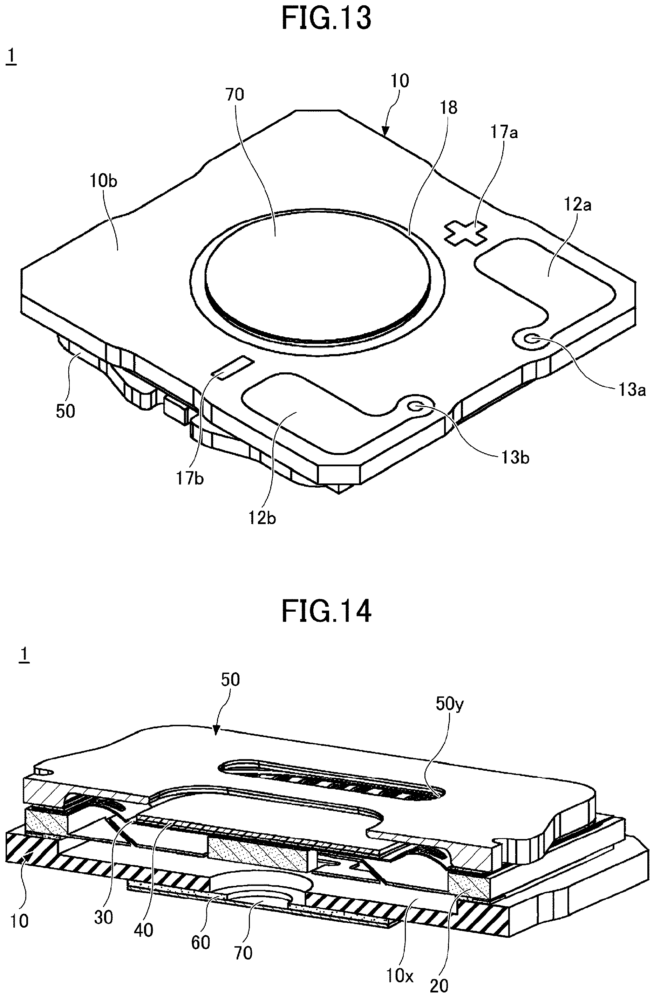

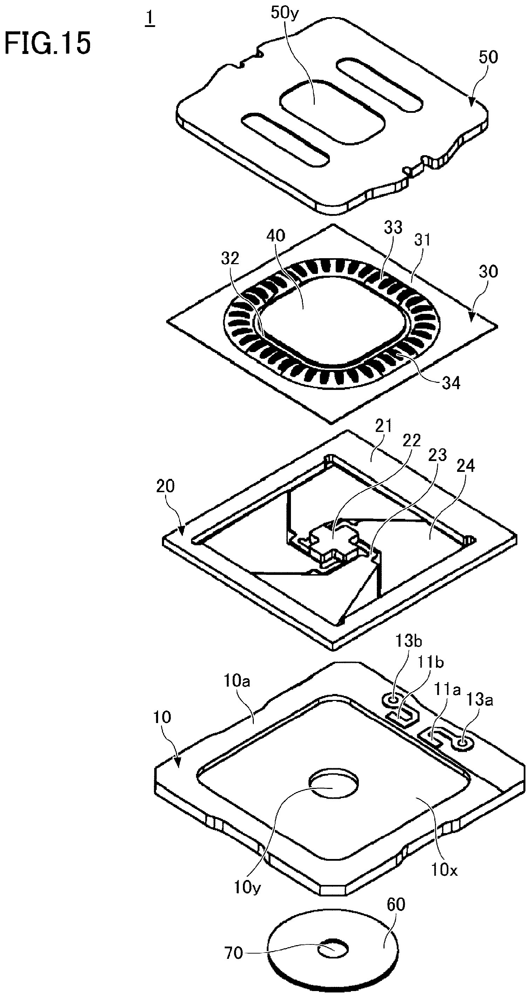

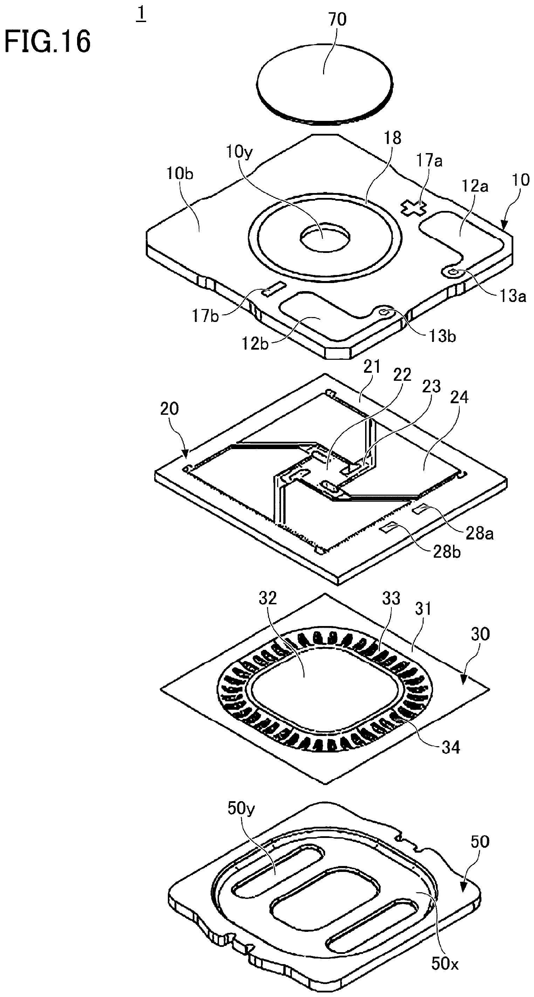

FIG. 12 is an upper side perspective view illustrating the electro-acoustic transducer according to the first embodiment. FIG. 13 is a lower perspective view illustrating the electro-acoustic transducer according to the first embodiment. FIG. 14 is a sectional view illustrating the electro-acoustic transducer according to the first embodiment, and illustrates a cross section taken along the line B-B in FIG. 12. FIG. 15 is an upper exploded perspective view illustrating the electro-acoustic transducer according to the first embodiment. FIG. 16 is a lower exploded perspective view illustrating the electro-acoustic transducer according to the first embodiment.

Referring to FIGS. 12 to 16, an electro-acoustic transducer 1 includes a substrate 10, the MEMS device 20, a membrane 30, a vibrating plate 40, a lid member 50, and a mesh 70. The electro-acoustic transducer 1 is an earpiece or a built-in speaker.

The substrate 10 is a base member of the electro-acoustic transducer 1. The substrate 10 may be, for example, a glass epoxy substrate. A silicon substrate or a ceramic substrate may be used as the substrate 10. The thickness of the substrate 10 may be, for example, about 0.2 mm to 0.6 mm. The substrate 10 has a wiring layer formed of, for example, gold, copper, or the like. The wiring layer may be provided on an upper surface 10a and/or a lower surface 10b of the substrate 10, or may be provided inside the substrate 10. In other words, the substrate 10 may be a multilayer wiring substrate. The wiring layer may include pads, through-wirings, dummy wirings, and the like.

On the upper surface 10a of the substrate 10, a pair of internal connection pads 11a and 11b, which serve as a path for supplying signals to all drive sources 25, is arranged. On the lower surface 10b of the substrate 10, a pair of external connection pads 12a and 12b for supplying signals from the outside of the electro-acoustic transducer 1 to the electro-acoustic transducer 1 is arranged.

The internal connection pad 11a and the external connection pad 12a are electrically connected via a through-wiring 13a that penetrates the substrate 10 from the upper surface 10a to the lower surface 10b. Similarly, the internal connection pad 11b and the external connection pad 12b are electrically connected via a through-wiring 13b that penetrates the substrate 10 from the upper surface 10a to the lower surface 10b.

A positive polarity mark 17a and a negative polarity mark 17b, indicating the respective polarities of external connection pads 12a and 12b, are disposed on the lower surface 10b of the substrate 10. The positive polarity mark 17a indicates that the external connection pad 12a is a "+" terminal, and the negative polarity mark 17b indicates that the external connection pad 12b is a "-" terminal.

An alignment mark 18 for the mesh 70 is disposed on the lower surface 10b of the substrate 10 so as to surround the through-hole 10y. For example, when the mesh 70 is circular, the alignment mark 18 can be made ringshaped. In this case, alignment of the mesh 70 can be performed by making an inner diameter of the ring equal to a diameter of the mesh 70.

The positive polarity mark 17a, the negative polarity mark 17b, and the alignment mark 18 can be formed, for example, of the same metal material as the external connection pads 12a and 12b. The thickness of the positive polarity mark 17a, the negative polarity mark 17b, and the alignment mark 18 can be the same as that of the external connection pads 12a and 12b, for example. The positive polarity mark 17a, the negative polarity mark 17b, and the alignment mark 18 may be electrically unconnected (floating).

The external connection pads 12a and 12b, the positive polarity mark 17a, the negative polarity mark 17b, and the alignment mark 18 protrude from the lower surface 10b of the substrate 10. On the lower surface 10b of the substrate 10, a resin film may be disposed by printing or the like in regions where the external connection pads 12a and 12b, the positive polarity mark 17a, the negative polarity mark 17b, and the alignment mark 18 are not provided. An example of the resin film includes a polyimide film.

By setting the thickness of the resin film to be equal to the thickness of the external connection pads 12a and 12b, the positive polarity mark 17a, the negative polarity mark 17b, and the alignment mark 18, a lower surface 10b-side of the substrate 10 can be flattened. In this arrangement, when the electro-acoustic transducer 1 is disposed on a predetermined plane with the lower surface 10b-side of the substrate 10 that faces downward, tilting of the electro-acoustic transducer 1 with respect to the predetermined plane can be prevented.

A pair of internal connection pads 11a and 11b of the substrate 10 is electrically connected to a pair of conduction pads 28a and 28b arranged on the lower surface of the fixed portion 21 of the MEMS device 20, via a conductive bonding material.

The substrate 10 has a frame-shaped upper surface 10a, the lower surface 10b, and a cavity portion 10x that is recessed from the upper surface 10a-side toward the lower surface 10b-side. When a drive voltage is applied, the movable portion 22 of the MEMS device 20 displaces toward the substrate 10. In this case, if the substrate 10 does not have the cavity portion 10x and the upper surface of the substrate 10 is flat, the movable portion 22 may come into contact with the substrate 10. By providing the cavity portion 10x in the substrate 10, such a concern is eliminated. The depth from the upper surface 10a of the substrate 10 to the lower surface of the cavity portion 10x is determined in consideration of maximum displacement of the movable portion 22, and such a depth can be, for example, about 0.1 mm to 0.4 mm.

The cavity portion 10x may be formed by bonding a frame-shaped substrate to the outer periphery of the plate-shaped substrate, or may be formed by forming a recess in a central portion of one plate-shaped substrate by mechanical processing. That is, the substrate 10 may be formed by bonding a plurality of substrates, or may be formed by mechanically processing one substrate.

Although a structure in which a through-hole is provided instead of the cavity portion 10x in the substrate 10 could be considered, the rigidity of the entire electro-acoustic transducer 1 cannot be ensured in such a structure. Thus, the structure in which the cavity portion 10x is provided in the substrate 10 is more advantageous.

Moreover, by providing the cavity portion 10x in the substrate 10, back volume of the electro-acoustic transducer 1 can be formed. In this arrangement, the effect of reducing the sharpness at the resonance frequency can be provided.

It is preferable that a through-hole 10y is provided in the substrate 10. The through-hole 10y can be provided in the central portion of the cavity portion 10x in plan view, for example. The through-hole 10y serves as a passage for air to enter and exit the inside of the substrate 10. In other words, by providing the through-hole 10y, air can enter and exit the through-hole 10y, and thus air resistance when the movable portion 22 of the MEMS device 20 moves can be reduced. As a result, the movable portion 22 can move more easily and the displacement of the movable portion 22 can be increased.

The MEMS device 20 is disposed on the substrate 10 with the drive sources 25 that face the substrate 10. In the MEMS device 20, for example, the lower surface of the fixed portion 21 can be bonded to the upper surface 10a of the substrate 10 via an adhesive layer. The adhesive layer can be formed of, for example, a thermosetting adhesive. An example of the thermosetting adhesive includes, for example, an epoxy adhesive. The adhesive layer may be formed of a double-sided tape or an ultraviolet curable adhesive.

The outer surface of the fixed portion 21 is exposed to the outside of the electro-acoustic transducer 1. In other words, in the electro-acoustic transducer 1, no other components are disposed outside the outer surface of the fixed portion 21. In plan view, the movable portion 22, the torsion beam 23, the drive beam 24, and the drive source 25 are located at positions overlapping the cavity portion 10x.

In this arrangement, by directly bonding the lower surface of the fixed portion 21 of the MEMS device 20 and the upper surface 10a of the substrate 10, other components such as frames for bonding are not required, and no components are disposed outside the outer surface of the fixed portion 21. Therefore, the electro-acoustic transducer 1 can be made compact.

The membrane 30 is a film-like member having flexibility and is disposed on the MEMS device 20. The membrane 30 is, for example, rectangular in plan view. However, the above example is not limiting. The membrane 30 may have other shapes such as circular, elliptical, triangular, or polygonal shapes having five or more sides in plan view.

The membrane 30 has a frame 31, a central portion 32 positioned inside the inner edge of the frame 31, and a connection portion 33 connecting an inner edge of the frame 31 and an outer edge of the central portion 32. In the membrane 30, the upper surface of the frame 31 and the upper surface of the central portion 32 are positioned in the same plane, for example, and the lower surface of the frame 31 and the lower surface of the central portion 32 are positioned in the same plane, for example. The connection portion 33 protrudes toward the lid member 50 from the upper surfaces of the frame 31 and the central portion 32, and the upper surface and the lower surface of the connection portion 33 have shapes curved in the same direction in a cross-sectional view taken in a direction perpendicular to the upper surface of the central portion 32.

A structure may be such that the upper and lower surfaces of the frame 31 are not in the same plane as the upper and lower surfaces of the central portion 32. For example, the structure may be configured to offset the height of the central portion 32 relative to the frame 31 by intentionally changing a molding condition of the membrane 30. A distance between the upper surface of the frame 31 and the upper surface of the central portion 32 may be, for example, about 20 µm to 100 µm. A distance between the lower surface of the frame 31 and the lower surface of the central portion 32 may be, for example, about 20 µm to 100 µm.

The connection portion 33 has a plurality of slits 34 arranged at predetermined intervals in a direction substantially perpendicular to an annular extension direction. With such a structure, when the membrane 30 vibrates, displacement of the central portion 32 caused by displacement of the movable portion 22 becomes unlikely to be suppressed by tension from the frame 31 that is fixed to the fixed portion 21.

A thickness of the membrane 30 can be, for example, about 5 µm to 50 µm. The membrane 30 can be composed of, for example, an elastomer or a resin. Examples of the elastomer include TPEE (polyester elastomer) and TPU (polyurethane elastomer). Examples of the resin include PET (polyethylene terephthalate), PI (polyimide), and PEEK (polyether ether ketone). The membrane 30 may be formed of a thin metal.

Although it is preferable that the frame 31, the central portion 32, and the connection portion 33 have an integral structure from the viewpoint of simplification of the structure and ease of processing, these portions may have a structure in which different members are bonded together. When the frame 31, the central portion 32, and the connection portion 33 have an integral structure, the membrane 30 can be formed by heating and pressurizing a resin film using a mold, for example.

In the membrane 30, the lower surface of the frame 31 can be bonded to the upper surface of the fixed portion 21 of the MEMS device 20 through an adhesive layer, for example. The lower surface of the central portion 32 can be bonded to the upper surface of the movable portion 22 of the MEMS device 20 through an adhesive layer, for example. The adhesive layer can be formed of, for example, a thermosetting adhesive. An example of the thermosetting adhesive includes, for example, an epoxy-based adhesive. The adhesive layer may be formed of a double-sided tape or an ultraviolet curable adhesive. In plan view, the central portion 32 of the membrane 30 and the connection portion 33 are located inside the fixed portion 21 of the MEMS device 20, and overlap with the cavity portion 10x of the substrate 10.

In this arrangement, with the structure in which the membrane 30 is fixed to the upper surface of the fixed portion 21 of the MEMS device 20, it becomes unnecessary to provide a frame for fixing the membrane 30 outside the fixed portion 21 of the MEMS device 20. As a result, since the shape of the MEMS device 20 can be maximized to approximately match the outline constraints of the electro-acoustic transducer 1, the area of the drive source 25 is increased, and thus the movable portion 22 can be moved with high torque and large displacement. As a result, high sound pressure can be obtained in the electro-acoustic transducer 1. In addition, since the frame becomes unnecessary, the number of components can be reduced, and thus takt time can be reduced through decreased work steps. In addition, manufacturing equipment costs can be reduced.

The central portion 32 of the membrane 30 vibrates in response to the vibration of the movable portion 22 of the MEMS device 20. In this arrangement, sound waves having frequencies in an audible range in accordance with vibration of the movable portion 22 of the MEMS device 20 are generated.

In the examples of FIGS. 12 to 16, the vibrating plate 40 is fixed to the upper surface of the central portion 32 of the membrane 30. Although soft physical properties are required for the membrane 30 alone, it is preferable to provide a rigid region in order to increase sound pressure. By disposing the vibrating plate 40 on the central portion 32 of the membrane 30, the central portion 32 becomes a rigid region, and thus sound pressure can be increased.

As the material of the vibrating plate 40, resin such as PEN (polyethylene naphthalate) can be used, for example. As the material of the vibrating plate 40, metal such as aluminum or carbon can be used. The vibrating plate 40 can be fixed to the upper surface of the central portion 32 of the membrane 30 through, for example, an adhesive or a double-sided tape. The thickness of the vibrating plate 40 can be, for example, about 25 µm to 100 µm. The vibrating plate 40 may be disposed on the lower surface of the central portion 32 of the membrane 30.

The lid member 50 is disposed on the membrane 30 as necessary. By providing the lid member 50, the membrane 30 can be protected, and the rigidity of the entire electro-acoustic transducer 1 can be increased. When attaching the electro-acoustic transducer 1 to other members, the lid member 50 can be used as an attachment reference.

The lid member 50 has a cavity portion 50x on the lower surface side. The outer peripheral region that is located outside the cavity portion 50x of the lid member 50 is used as a frame-shaped thick plate portion, and the cavity portion 50x is a thin plate portion disposed inside the thick plate portion. The lower surface of the thick plate portion of the lid member 50 can be bonded to the upper surface of the frame 31 of the membrane 30 via, for example, an adhesive layer. The adhesive layer can be formed from, for example, a thermosetting adhesive. An example of the thermosetting adhesive includes an epoxy adhesive. The adhesive layer can be formed from a double-sided tape or an ultraviolet curable adhesive. The cavity portion 50x includes one or more openings 50y, and sound waves are output through the openings 50y.

By having the lid member 50, the electro-acoustic transducer 1 can secure rigidity while maintaining a thin body. The thickness of the lid member 50 can be, for example, about 0.3 mm in the outer peripheral region that is located outside the cavity portion 50x, and also, the thickness of the lid member 50 can be about 0.1 mm in a portion of the cavity portion 50x.

As the material of the lid member 50, a metal such as SUS (stainless steel) or aluminum may be used. As the material of the lid member 50, a resin such as PC (polycarbonate) may be used. It is preferable to use a metal as the material of the lid member 50 from the viewpoint of ensuring rigidity while maintaining a thin body.

The mesh 70 is disposed on the lower surface 10b-side of the substrate 10 as needed. The mesh 70 has many small openings. A resin such as polyester can be used as the material of the mesh 70. The mesh 70 can be bonded to the lower surface 10b of the substrate 10 through an adhesive layer 60 having an opening at its center, so as to close the through-hole 10y of the substrate 10. The adhesive layer 60 is, for example, a double-sided tape.

By providing the mesh 70 and adjusting an opening ratio of the mesh 70, a Q value of the resonance frequency of the electro-acoustic transducer 1 can be lowered, and thus a nearly flat frequency characteristic can be realized. Moreover, by providing the mesh 70, the possibility of foreign matter such as dust and water entering the interior of the electro-acoustic transducer 1 can be reduced, while maintaining the flow of air through the through-hole 10y.

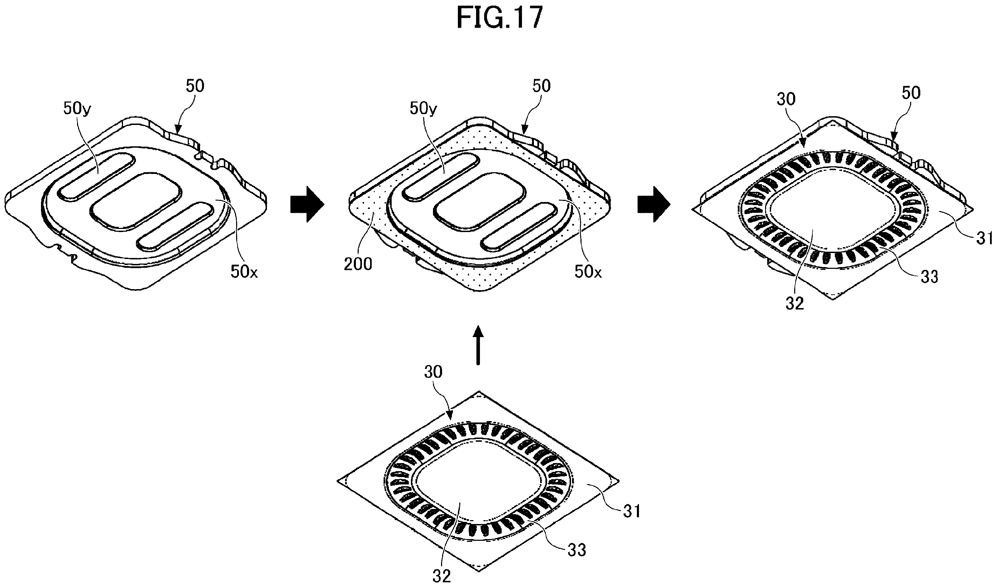

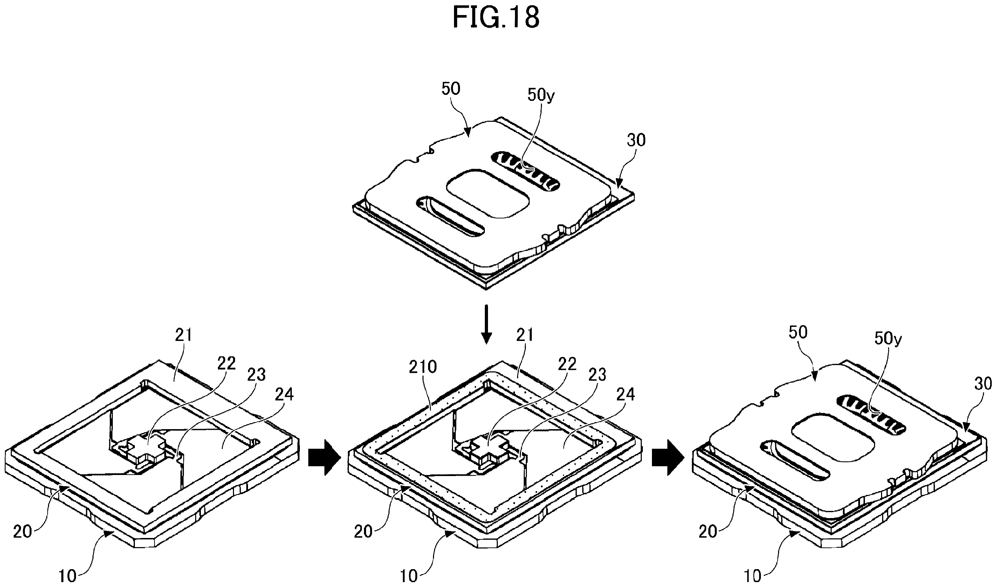

FIGS. 17 and 18 are diagrams for describing a manufacturing method of the electro-acoustic transducer according to the first embodiment. In FIGS. 17 and 18, thick arrows indicate the flow of the processes, and thin arrows indicate the supply of components. For convenience of explanation, FIG. 17 shows each member viewed from below, and FIG. 18 shows each member viewed from above. Adhesive layers 200 and 210 are shown in dot patterns for convenience.

First, as shown at the left end of FIG. 17, the lid member 50 having the cavity portion 50x and openings 50y is prepared. Next, as shown in the center of FIG. 17, an adhesive layer 200 is annularly disposed on the entire lower surface that surrounds the outer periphery of the cavity portion 50x of the lid member 50. The adhesive layer 200 can be formed of, for example, an epoxy-based adhesive. Next, the membrane 30 including the frame 31, the central portion 32, and the connection portion 33 is prepared, and as shown at the right end of FIG. 17, the upper surface of the frame 31 of the membrane 30 is bonded to the lower surface of a thick plate portion of the lid member 50 via the adhesive layer 200. Before bonding with the lid member 50, a vibrating plate 40 is preliminarily disposed on the central portion 32 of the membrane 30 by adhesion or the like.

Next, as shown at the left end of FIG. 18, the substrate 10 and the MEMS device 20 are prepared, and the MEMS device 20 is bonded to the substrate 10. Next, as shown in the center of FIG. 18, the adhesive layer 210 is annularly disposed on the upper surface of the fixed portion 21 of the MEMS device 20. The adhesive layer 210 can be formed of, for example, an epoxy adhesive. Then, as shown at the right end of FIG. 18, the assembly of the membrane 30 and the lid member 50 that is fabricated in FIG. 17 is bonded to the upper surface of the fixed portion 21 of the MEMS device 20 via the adhesive layer 210. Then, the mesh 70 is fixed via the adhesive layer 60, so as to close the through-hole 10y of the substrate 10. As a result, the electro-acoustic transducer 1 is completed. The mesh 70 may be preliminarily fixed to the substrate 10.

### <Second Embodiment>

In a second embodiment, an example shows different connection positions between the torsion beams and the movable portion, and between the torsion beams and the drive beams in the MEMS device.

FIG. 19 is an upper view illustrating the MEMS device according to the second embodiment. A MEMS device 20A shown in FIG. 19 differs from the MEMS device 20 (see FIG. 3 and the like) in the connection positions between the torsion beams 23 and the movable portion 22 and between the torsion beams 23 and the drive beams 24. In the MEMS device 20A, similar to the MEMS device 20, each of the drive beams 24 has a region where the width in a direction parallel to a first side 24a connected to the inner edge of the fixed portion 21 gradually increases toward the first side 24a in plan view.

In the MEMS device 20 shown in FIG. 3, the upper base of a trapezoid constituting the second region 24₂ is connected to the torsion beam 23 in plan view, while in the MEMS device 20A shown in FIG. 19, a lateral side of the trapezoid constituting the second region 24₂ on a side near the movable portion 22 is connected to the torsion beam 23. In addition, a lower base of the trapezoid constituting the first region 24₁ coincides with the first side 24a. In the MEMS device 20A, an upper base of the trapezoid constituting the first region 24₁ may coincide with a lower base of the trapezoid constituting the second region 24₂.

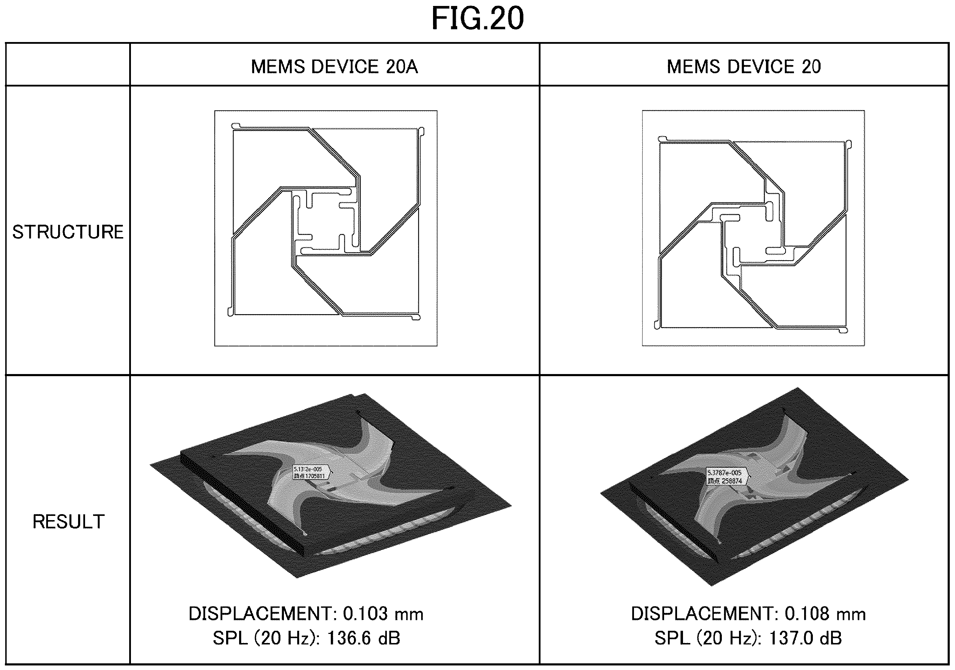

FIG. 20 shows a comparison result between the MEMS device 20A and the MEMS device 20, and the displacement of their movable portions 22 and a sound pressure level SPL at 20 Hz that is calculated through simulation. As shown in FIG. 20, there is no significant difference in characteristics between the MEMS device 20A and the MEMS device 20, and both may function sufficiently as MEMS speakers. However, the MEMS device 20 is slightly superior in both displacement and sound pressure level.

### <Third Embodiment>

In a third embodiment, an example shows that different shapes of membranes are employed in the electro-acoustic transducer.

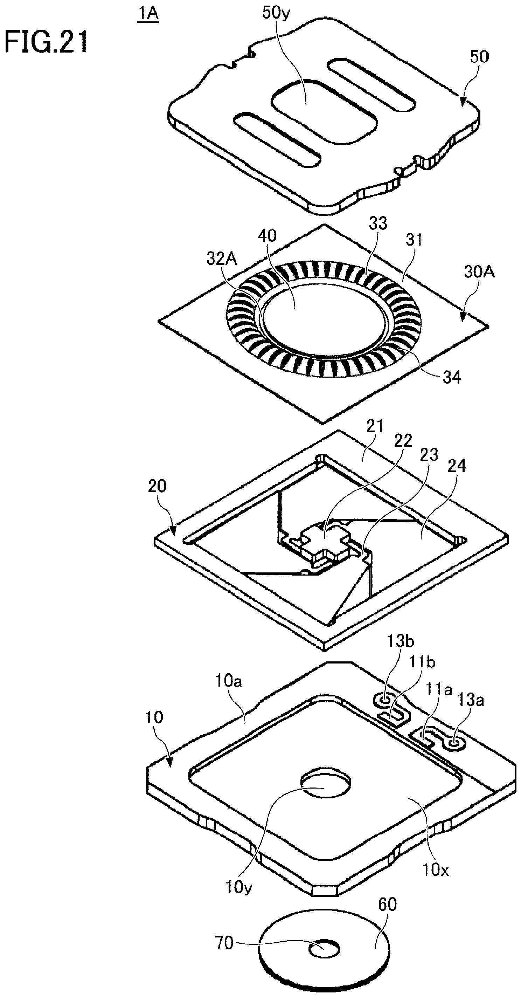

FIG. 21 is an upper exploded perspective view illustrating the electro-acoustic transducer according to the third embodiment. Referring to FIG. 21, an electro-acoustic transducer 1A differs from the electro-acoustic transducer 1 (see FIG. 15 and the like) in that the membrane 30 is replaced with a membrane 30A.

The membrane 30A has a frame 31 having a circular inner edge, a circular central portion 32A positioned inside the inner edge of the frame 31, and a connection portion 33 connecting the inner edge of the frame 31 and the outer edge of the central portion 32A. The lower surface of the central portion 32A is connected to the upper surface of the movable portion 22. A vibrating plate 40 is disposed on the upper surface of the central portion 32A. The vibrating plate 40 also has a circular shape corresponding to the shape of the central portion 32A.

In the membrane 30A, the upper surface of the frame 31 and the upper surface of the central portion 32A are positioned in the same plane, for example, and the lower surface of the frame 31 and the lower surface of the central portion 32A are positioned in the same plane, for example. The connection portion 33 protrudes from the upper surface of the central portion 32A, and in a cross-sectional view taken in a direction perpendicular to the upper surface of the central portion 32A, the upper and lower surfaces of the connection portion 33 have shapes curved in the same direction. The connection portion 33 has a plurality of slits 34 arranged along an annular shape, at predetermined intervals in a direction substantially perpendicular to extension directions thereof, and in plan view, a longitudinal direction of each slit 34 faces toward a center direction of the central portion 32A. In the plan view, the longitudinal direction of each slit 34 may be oriented in a tangential direction with respect to the circular inner edge of the frame 31. The frame 31, the central portion 32A, and the connection portion 33 have an integral structure, for example. As in a case of the membrane 30, a structure may be such that the upper and lower surfaces of the frame 31 are not in the same plane as the upper and lower surfaces of the central portion 32A.

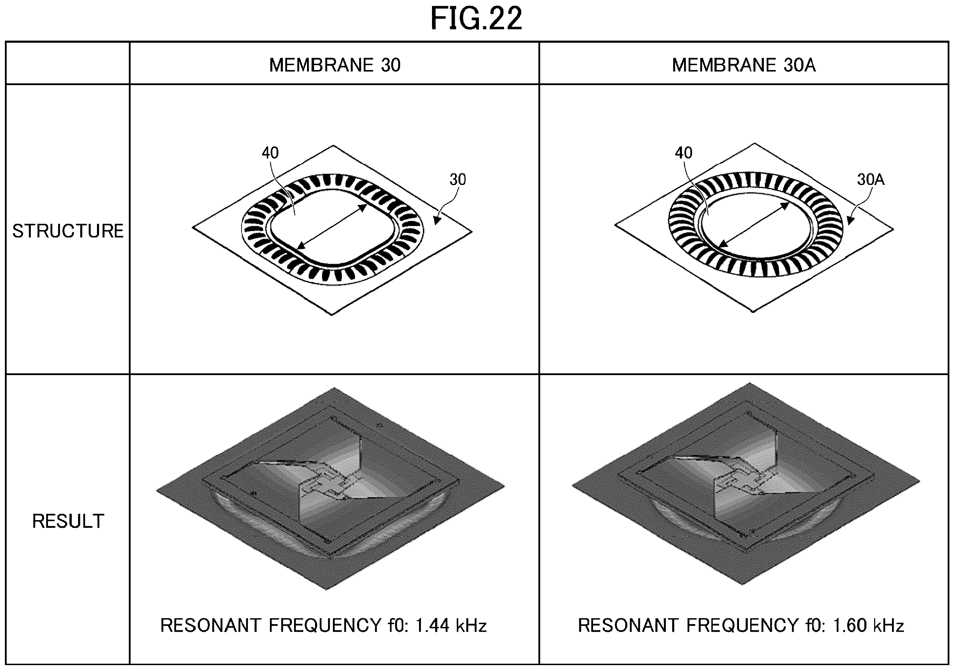

FIG. 22 is a simulation result of resonance frequencies of the MEMS device and the membrane. Although the illustration of the MEMS device 20 is omitted in a structure section of FIG. 22, the structure section shows the simulated resonance frequencies of the MEMS device and the membrane that is equipped with the vibrating plate. The materials and thicknesses for the membrane 30 and the membrane 30A are the same. In addition, the material and thickness for each vibrating plate 40 are the same, and the lengths of arrowed portions are equal.

As shown in FIG. 22, the resonance frequency of the membrane 30A is higher than that of the membrane 30. In other words, compared to a case where the central portion and the vibrating plate are rectangular, the circular shape becomes lighter in weight, making it easier to drive and resulting in a higher resonance frequency. In addition, when the central portion and the vibrating plate are circular, it is also preferable in that there is less distortion and unnecessary resonance in a torsional direction is less likely to occur.

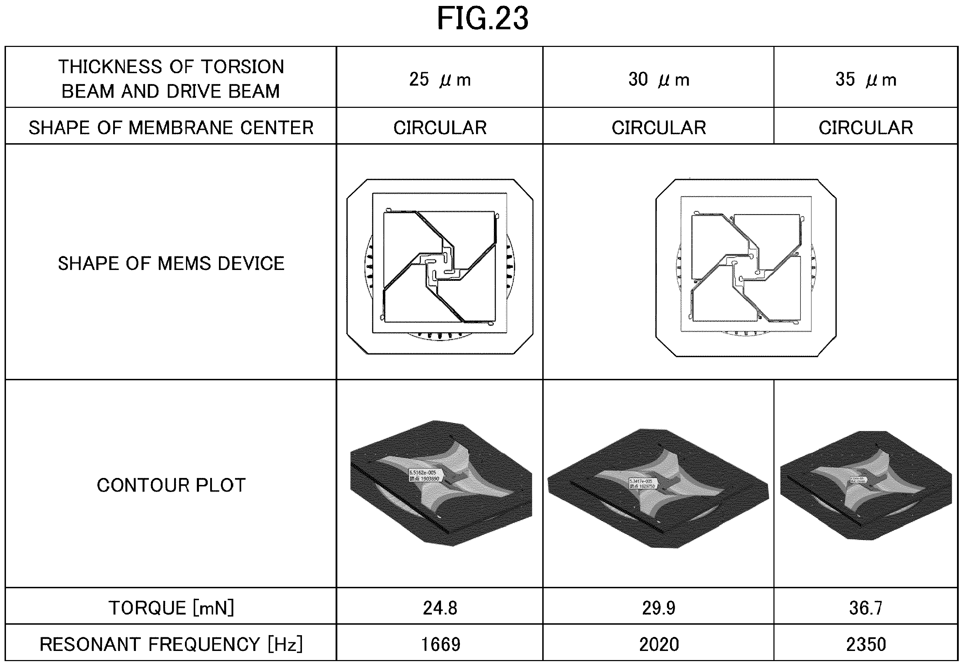

In this arrangement, a higher resonance frequency is obtained when the central portion 32A and the vibrating plate 40 of the membrane 30 are circular. Moreover, as described above, a higher resonance frequency is obtained when the weight of the movable portion 22 is reduced. Furthermore, as shown in FIG. 23, the resonance frequency also changes depending on the thicknesses of the torsion beams 23 and the drive beams 24. FIG. 23 is a simulation result of the resonance frequency when changing the thicknesses of the torsion beam and the drive beam. The thickness of the piezoelectric film that constitutes the drive source 25, and the number of layers of the piezoelectric film are kept constant.

As shown in FIG. 23, it can be seen that a higher resonance frequency can be obtained by making the central portion of the membrane and the vibrating plate circular, and by making the torsion beam 23 and the drive beam 24 thicker. For example, by setting the thickness of the torsion beam 23 and the drive beam 24 to be greater than or equal to 25 µm and less than or equal to 35 µm, the resonance frequency can be adjusted to about 1.5 kHz to 2.5 kHz. As described above, this corresponds to a preferable resonance frequency when the Harman curve is considered. As the thicknesses of the torsion beam 23 and the drive beam 24 are increased, higher torque can be obtained.

### <Fourth Embodiment>

In a fourth embodiment, an example shows the arrangement of pads for height adjustment and position alignment in the MEMS device.

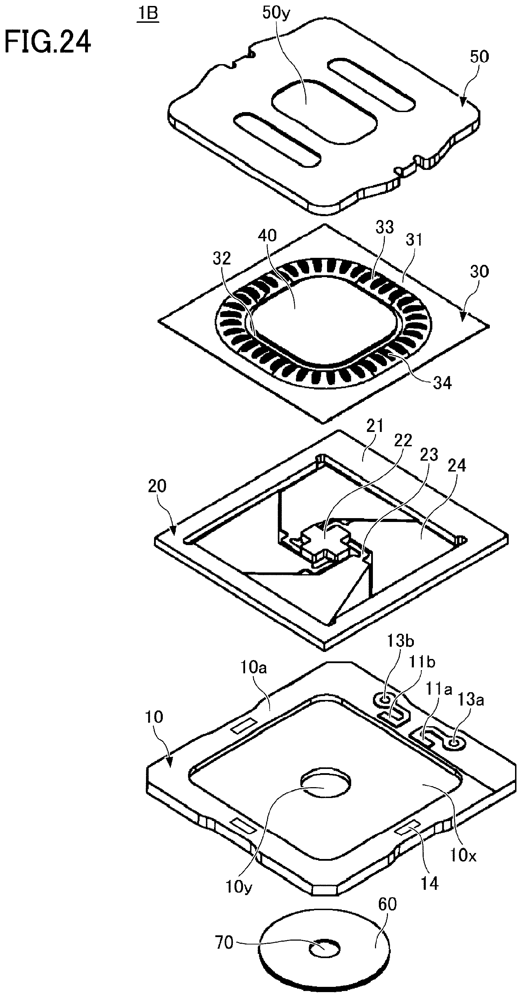

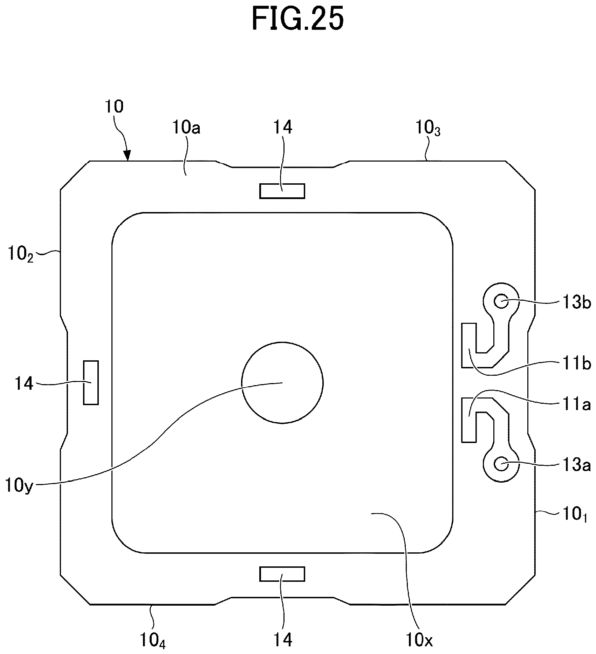

FIG. 24 is an upper exploded perspective view illustrating the electro-acoustic transducer according to the fourth embodiment. FIG. 25 is an upper view illustrating a substrate constituting the electro-acoustic transducer according to the fourth embodiment. Referring to FIGS. 24 and 25, an electro-acoustic transducer 1B differs from the electro-acoustic transducer 1 (see FIG. 15 and the like) in that one or more height adjustment pads 14 are added to a substrate 10.

In the electro-acoustic transducer 1B, in a region overlapping the fixed portion 21 of the MEMS device 20 in plan view, a pair of internal connection pads 11a and 11b, which serve as a path of a signal supplied to the drive source 25 of the MEMS device 20, and the height adjustment pads 14 are arranged on the upper surface 10a of the substrate 10. Each height adjustment pad 14 is arranged apart from the internal connection pads 11a and 11b. Since each height adjustment pad 14 is a dummy pad, the pad may be electrically unconnected (floating).

In the electro-acoustic transducer 1B, the lower surface of the fixed portion 21 of the MEMS device 20 is bonded to the upper surface 10a of the substrate 10, while the internal connection pads 11a and 11b and the height adjustment pads 14 are interposed between the lower surface of the fixed portion 21 and the upper surface 10a of the substrate 10.

The height adjustment pad 14 has the same height from the upper surface 10a of the substrate 10 as the internal connection pads 11a and 11b. The height (i.e., thickness) of the internal connection pads 11a and 11b and the height adjustment pad 14 from the upper surface 10a of the substrate 10 may be, for example, greater than or equal to 10 µm and less than or equal to 50 µm. The height adjustment pad 14 is provided to reduce the inclination of the MEMS device 20 that is disposed on the substrate 10, with respect to the upper surface 10a of the substrate 10.

In the present embodiment, in plan view, the substrate 10 is a rectangle having a first side 10₁ and a second side 10₂ opposing each other, and a third side 10₃ and a fourth side 10₄ opposing each other. The internal connection pads 11a and 11b are disposed along the first side 10₁.

In this case, the height adjustment pad 14 needs to be disposed at least along the second side 10₂. In order to more reliably reduce the inclination of the MEMS device 20, it is preferable that the respective height adjustment pads 14 are disposed along the second side 10₂, the third side 10₃, and the fourth side 10₄, as shown in FIG. 25. Three height adjustment pads 14 may be respectively disposed near the center of the second side 10₂, the third side 10₃, and the fourth side 10₄, for example.

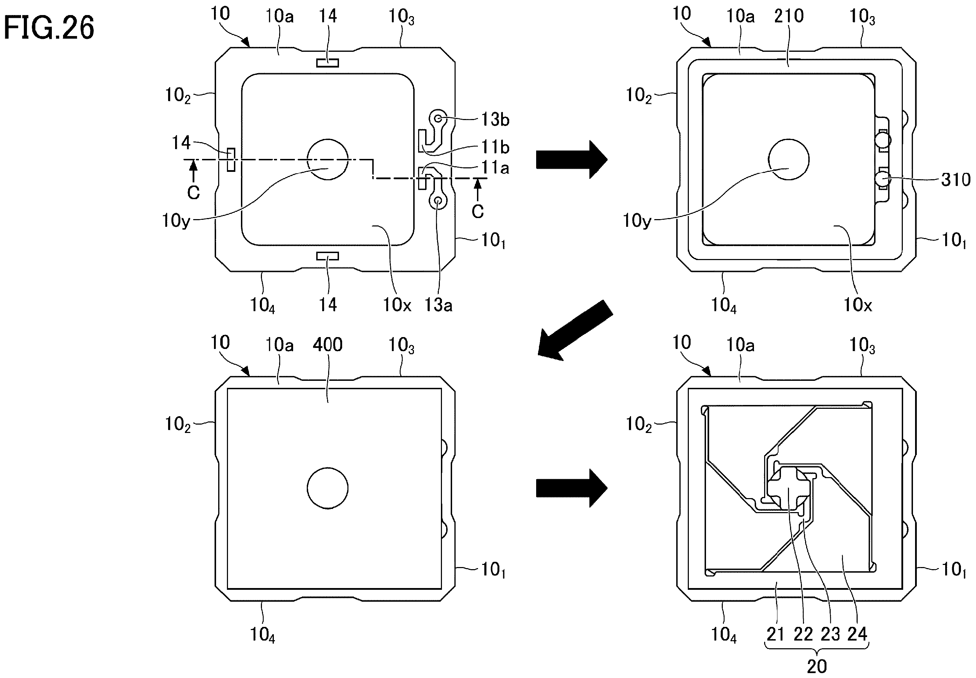

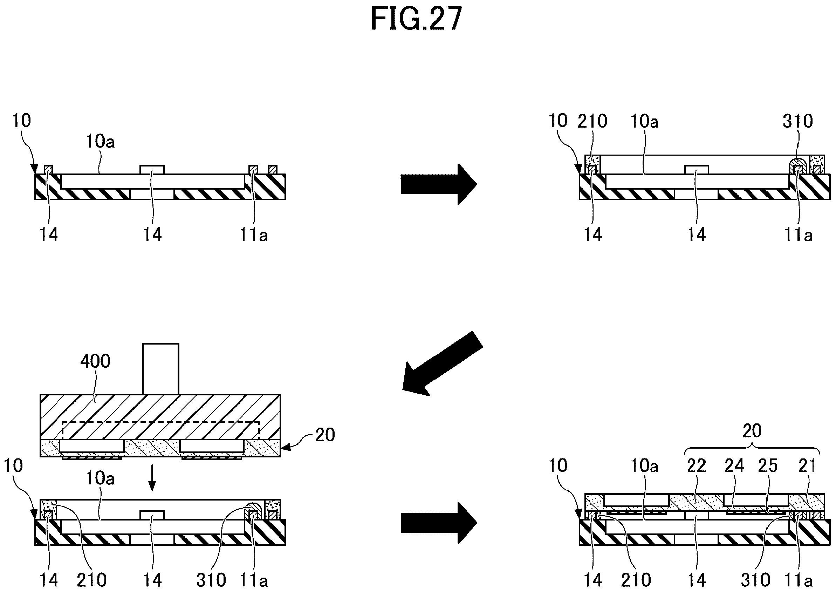

FIG. 26 is an upper view showing a process of arranging the MEMS device on the substrate. FIG. 27 is a cross-sectional view showing a process of arranging the MEMS device on the substrate, and shows a cross section taken along the line C-C of FIG. 26.

In order to arrange the MEMS device 20 on the substrate 10 as shown in each of FIGS. 26 and 27, first, the substrate 10 is prepared as shown at the base of a first arrow in each of FIGS. 26 and 27. Next, following the first arrow, the adhesive layer 210 is annularly arranged on the upper surface 10a of the substrate 10, so as to expose internal connection pads 11a and 11b and cover the height adjustment pads 14. Also, conductive bonding materials 310 are disposed on the internal connection pads 11a and 11b exposed from the adhesive layer 210. The conductive bonding material 310 is, for example, a conductive paste (for example, silver paste) or solder.

Next, following a second arrow, the MEMS device 20 is attracted to an attraction jig 400, and is moved onto the substrate 10 to perform alignment. Then, following a third arrow, the attraction jig 400 is lowered to place and press the MEMS device 20 on the substrate 10. Then, the attraction is released, and the attraction jig 400 is moved from the MEMS device 20. At this time, since the MEMS device 20 is supported by the internal connection pads 11a and 11b and the height adjustment pads 14, the MEMS device 20 can be fixed to the upper surface 10a of the substrate 10 with little inclination.

In other words, parallelism between the substrate 10 and the MEMS device 20 can be maintained, and the electrical conduction between the substrate 10 and the MEMS device 20 and the sealing by the adhesive layer 210 can be reliably performed. Moreover, the substrate 10, the MEMS device 20, and the adhesive layer 210 can secure a space region as designed.

In this arrangement, by arranging the height adjustment pads 14, accuracy of assembling the MEMS device 20 with one or more peripheral components can be improved.

Instead of providing the height adjustment pads 14, a design where the number of internal connection pads is increased and the internal connection pads are arranged along other sides in addition to the first side 10₁, for example, can be considered. However, in this case, this is not desirable because the substrate 10 becomes larger as a through-wiring and the like connected to the internal connection pads need to be arranged along each side. Further, when the number of internal connection pads increases, there is a concern about decreased connection reliability because the number of locations to be bonded using a conductive bonding material increases. As in the present embodiment, by having only one pair of internal connection pads and providing height adjustment pads separate from the internal connection pads, these concerns are resolved.

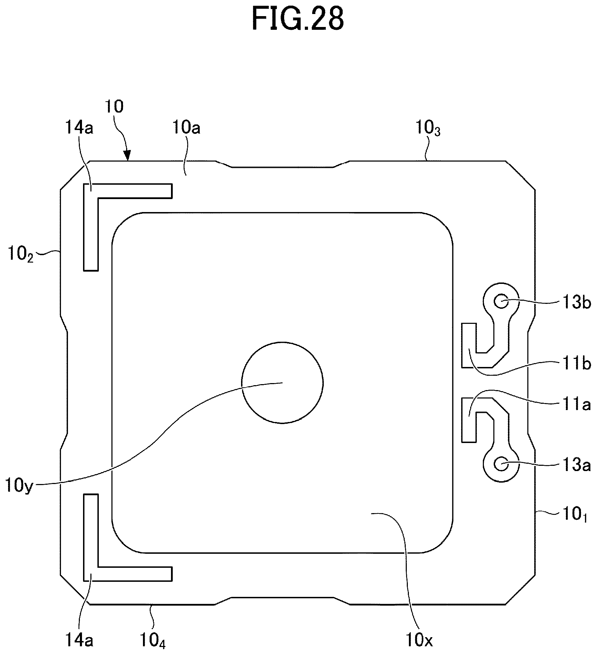

FIG. 28 is an upper view illustrating the substrate constituting the electro-acoustic transducer in a first modification of the fourth embodiment. In FIG. 28, two height adjustment pads 14a are disposed on the upper surface 10a of the substrate 10. Specifically, the height adjustment pads 14a are disposed one each along a corner portion connecting the second side 10, and the third side 10₃ and a corner portion connecting the second side 10, and the fourth side 10₄.

Also, in the case of FIG. 28, when the MEMS device 20 is arranged on the substrate 10, the MEMS device 20 is supported by the internal connection pads 11a and 11b and the height adjustment pads 14a. In this arrangement, the MEMS device 20 can be fixed to the upper surface 10a of the substrate 10 with little inclination.

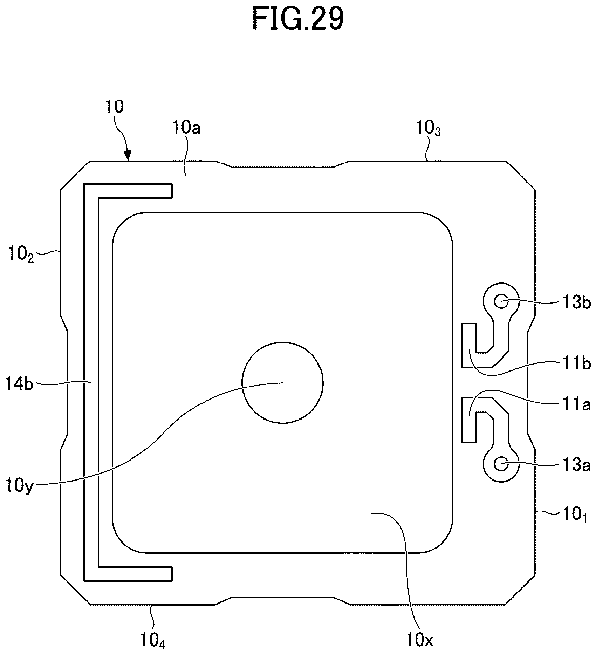

FIG. 29 is an upper view illustrating the substrate constituting the electro-acoustic transducer in a second modification of the fourth embodiment. In FIG. 29, one height adjustment pad 14b is disposed on the upper surface 10a of the substrate 10. Specifically, the height adjustment pad 14b is disposed along the second side 10₂, and is disposed, so as to extend to a corner connecting the second side 10₂ and the third side 10₃, and to a corner portion connecting the second side 10₂ and the fourth side 10₄.

Also in the case of FIG. 29, when the MEMS device 20 is disposed on the substrate 10, the MEMS device 20 is supported by the internal connection pads 11a and 11b and the height adjustment pad 14b. In this arrangement, the MEMS device 20 can be fixed to the upper surface 10a of the substrate 10 with little inclination.

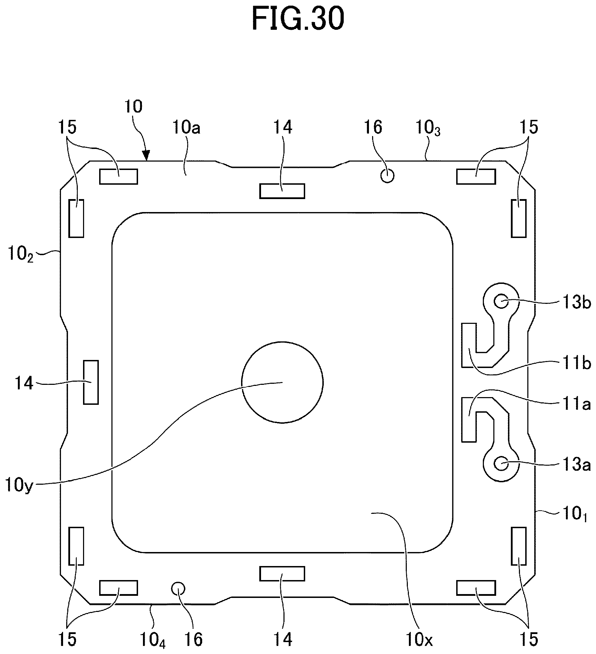

FIG. 30 is an upper view illustrating the substrate constituting the electro-acoustic transducer in a third modification of the fourth embodiment. In FIG. 30, first alignment pads 15 and second alignment pads 16 are disposed on the upper surface 10a of the substrate 10, in addition to three height adjustment pads 14.

Specifically, the first alignment pads 15 are arranged in respective regions that are located on the upper surface 10a of the substrate 10 and are outside the fixed portion 21 of the MEMS device 20 in plan view. In an example of FIG. 30, the first alignment pads 15 are arranged one each along both ends of each side of the substrate 10, with a total of eight pads arranged.

The second alignment pads 16 are arranged in respective regions that are located on the upper surface 10a of the substrate 10 and are outside the fixed portion 21 of the MEMS device 20 in plan view. In the example of FIG. 30, one of the second alignment pads 16 is arranged along each of a pair of opposing sides of the substrate 10, with a total of two pads arranged. For example, in plan view, the second alignment pads 16 can be each arranged at a position interposed between two first alignment pads 15 that are arranged along the same side of the substrate 10.

In FIGS. 26 and 27, the first alignment pads 15 and/or the second alignment pads 16 can be used for alignment when the adhesive layer 210 and the MEMS device 20 are arranged on the substrate 10. Specifically, the first alignment pads 15 can be used for positioning when the MEMS device 20 is arranged on the substrate 10 using, for example, a device such as the attraction jig 400. The second alignment pads 16 can be used as recognition marks when the adhesive layer 210 is arranged on the substrate 10 by, for example, a device such as a robot.

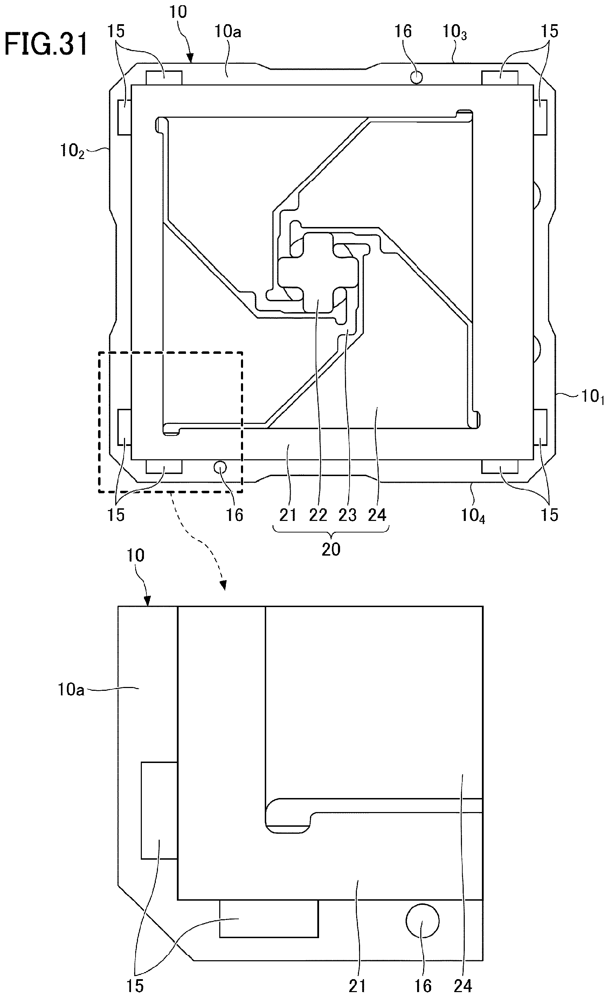

FIG. 31 is an upper view showing a state of positioning the MEMS device on the substrate. The upper part of FIG. 31 is an overall view of the substrate 10 and the MEMS device 20, and the lower part is an enlarged view inside an upper dashed line.

As shown in FIG. 31, when using first alignment pads 15 for positioning, these alignment pads 15 are arranged such that the side of each of the first alignment pads 15 facing toward the center of the substrate 10 coincides with the outer edge of the MEMS device 20 in plan view. In this arrangement, position alignment between the MEMS device 20 and the substrate 10 can be performed.

When using the second alignment pads 16 for positioning, position alignment between the MEMS device 20 and the substrate 10 can be performed by recognizing the two second alignment pads 16 as recognition marks. Moreover, position alignment between the adhesive layer 210 and the substrate 10 can be performed by recognizing the two second alignment pads 16 as recognition marks.

Both the first alignment pad 15 and the second alignment pad may be provided on the substrate 10, or only one of the first alignment pad and the second alignment pad 16 may be provided suitable for the specifications of a target device to be used. For example, by selecting the target device, both position alignment of the adhesive layer 210 on the substrate 10 and position alignment of the MEMS device 20 can be performed using only the second alignment pads 16.

In this arrangement, by arranging the first alignment pad 15 and/or the second alignment pad 16, accuracy of assembling the MEMS device 20 with one or more peripheral components can be improved.

### (Fifth Embodiment)

In a fifth embodiment, an example shows routing of wirings arranged in the MEMS device.

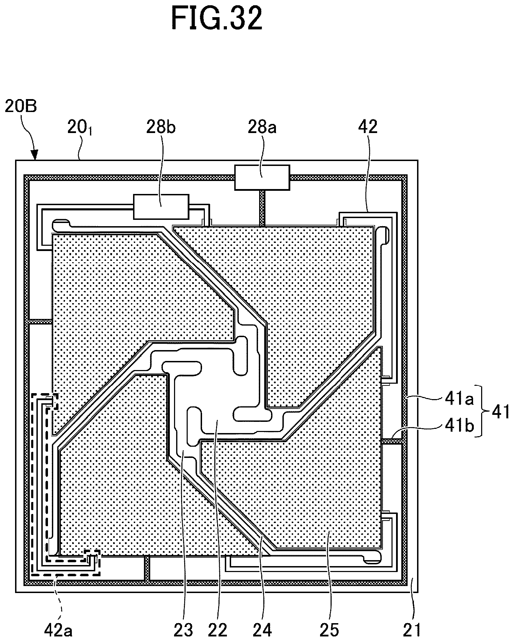

FIG. 32 is a lower view illustrating the wirings in the MEMS device according to the fifth embodiment. Referring to FIG. 32, a MEMS device 20B has a pair of conduction pads 28a and 28b, a first wiring 41, and a second wiring 42.

The conduction pads 28a and 28b, the first wiring 41, and the second wiring 42 serve as paths for signals that are supplied to a drive source 25 of the MEMS device 20B. The conduction pads 28a and 28b, the first wiring 41, and the second wiring 42 can be disposed, for example, on the lower surface of the fixed portion 21. The first wiring 41 and the second wiring 42 may extend from the lower surface of the fixed portion 21 to the lower surfaces of the drive beam 24, the torsion beam 23, and the movable portion 22.

The conduction pads 28a and 28b, the first wiring 41, and the second wiring 42 can be formed, for example, of gold. The thickness of the conduction pads 28a and 28b, the first wiring 41, and the second wiring 42 can be, for example, approximately greater than or equal to 0.05 µm and less than or equal to 1.00 µm.

The first wiring 41 electrically connects the conduction pad 28a, which is one of the pair of conduction pads, with one of the electrodes of each drive source 25. The second wiring 42 electrically connects the conduction pad 28b, which is the other of the pair of conduction pads, with the other of the electrodes of each drive source 25.

Specifically, when each drive source 25 has an upper electrode and a lower electrode, and no intermediate electrode, for example, the first wiring 41 is connected to the lower electrode, and the second wiring 42 is connected to the upper electrode. Alternatively, the first wiring 41 may be connected to the upper electrode, and the second wiring 42 may be connected to the lower electrode.

When each drive source 25 has an upper electrode, a lower electrode, and an intermediate electrode, the first wiring 41 is connected to the upper electrode and the lower electrode, and the second wiring 42 is connected to the intermediate electrode. Alternatively, the first wiring 41 may be connected to the intermediate electrode, and the second wiring 42 may be connected to the upper electrode and the lower electrode.

The first wiring 41 includes an annular wiring 41a that extends from the conduction pad 28a, is annularly arranged so as to surround the plurality of drive sources 25 in plan view, and returns to the conduction pad 28a. Also, the first wiring 41 includes a branch wiring 41b that branches from the annular wiring 41a and is connected to each drive source 25. The second wiring 42 is arranged inside the annular wiring 41a in plan view.

In an example of FIG. 32, the second wiring 42 extends from the conduction pad 28b, passes through each drive source 25, and returns to the conduction pad 28b. For example, the second wiring 42 includes four portions 42a that directly connect adjacent drive sources 25. Each portion 42a is arranged along a portion of the annular wiring 41a that connects adjacent branch wirings 41b. This arrangement makes it easy for the second wiring 42 to extend from the conduction pad 28b, pass through each drive source 25, and return to the conduction pad 28b.

In this arrangement, in the MEMS device 20B, the first wiring 41 includes the annular wiring 41a and the branch wiring 41b. Also, the second wiring 42 extends from the conduction pad 28b, passes through each drive source 25, and returns to the conduction pad 28b. This arrangement makes it possible to shorten the paths of the first wiring 41 and the second wiring 42 connecting the conduction pads 28a and 28b to each drive source 25.

Therefore, the delay of signals input to the drive sources 25 that is far from the conduction pads 28a and 28b with respect to signals input to the drive sources 25 near the conduction pads 28a and 28b can be suppressed. In other words, a signal with a small phase difference can be input to both the drive source 25 near the conduction pads 28a and 28b and the drive source 25 far from the conduction pads 28a and 28b. As a result, the displacement of the movable portion 22 can be increased.

Moreover, if there is a phase difference in the signal that is input to each drive source 25, the drive source 25 might drive in a direction of canceling the displacement of the movable portion 22. However, in the MEMS device 20B, signals with small phase differences are input to the respective drive sources 25, and the displacement of the movable portion 22 is difficult to be canceled, and thus the frequency characteristic of the MEMS device 20B can be improved. This effect is particularly notable when the signal frequency is high.

It is preferable that the first wiring 41 is connected to a ground wiring of an external circuit, and the second wiring 42 is connected to a signal wiring of the external circuit. In this case, since the second wiring 42 connected to the signal wiring is surrounded by the first wiring 41 connected to the ground wiring, the possibility that noise is superimposed on the second wiring 42 can be reduced.

In the example shown in FIG. 32, it is possible to make the MEMS device 20B compact and to improve the connection reliability between the MEMS device 20B and the substrate 10. This will be described in detail below.

The fixed portion 21 of the MEMS device 20B requires a certain width for the reasons such as securing an adhesion area to the substrate 10, securing an area for arranging the first wiring 41 and the second wiring 42, and securing an area for arranging the conductive bonding material used to connect the internal connection pads 11a and 11b of the substrate 10. If the width of the fixed portion 21 is made symmetrical in the horizontal direction, the dimensions of the fixed portion 21 in the horizontal direction would become large. If the width of the fixed portion 21 is made symmetrical in the vertical and horizontal directions, the outer shape of the fixed portion 21 would become large in the vertical and horizontal directions.

Therefore, as shown in FIG. 32, in the MEMS device 20B, a portion along a first side 20₁ is made wider than a portion along the other three sides, and thus the center of the outer edge of the fixed portion 21 does not coincide with the center of the movable portion 22. For example, the width of the portion along the first side 20₁ can be 0.9 mm, and the width of the portion along the other three sides can be 0.5 mm. In a widened portion along the first side 20₁, only one pair of conduction pads 28a and 28b is arranged for a plurality of drive sources 25. With such a structure, the width of the portion along the other three sides other than the first side 20₁ can be reduced, and thus the MEMS device 20B can be made compact.

In other words, a configuration in which one pair of conduction pads is arranged for each drive source 25 is considered. However, if there are four drive sources 25, eight conduction pads are required, and thus the MEMS device becomes large in order to secure a space for arranging the conduction pads. The MEMS device 20B can be made compact by having only one pair of conduction pads 28a and 28b.

Moreover, the conduction pads 28a and 28b are connected to the internal connection pads 11a and 11b of the substrate 10 via one or more conductive bonding materials, and since the number of connected pads is small, high connection reliability can be obtained. Moreover, since the connection between the conduction pads 28a and 28b and the pads of the substrate 10 becomes easy, costs can be reduced.

As shown in FIG. 25 and the like, the portion along one side of the substrate 10 may be made wider than the portion along the other three sides, and the center of the outer edge of the substrate 10 may not coincide with the center of the through-hole 10y. The internal connection pads 11a and 11b and the through-wirings 13a and 13b can be arranged in the widened portion. With such a structure, the width of the portion along the other three sides, except a portion where the internal connection pads 11a and 11b and the through-wirings 13a and 13b are arranged, can be reduced, and as a result, the substrate 10 can be made compact. Furthermore, by reducing the substrate 10 and the MEMS device 20B in size, the entire electro-acoustic transducer can be made compact.

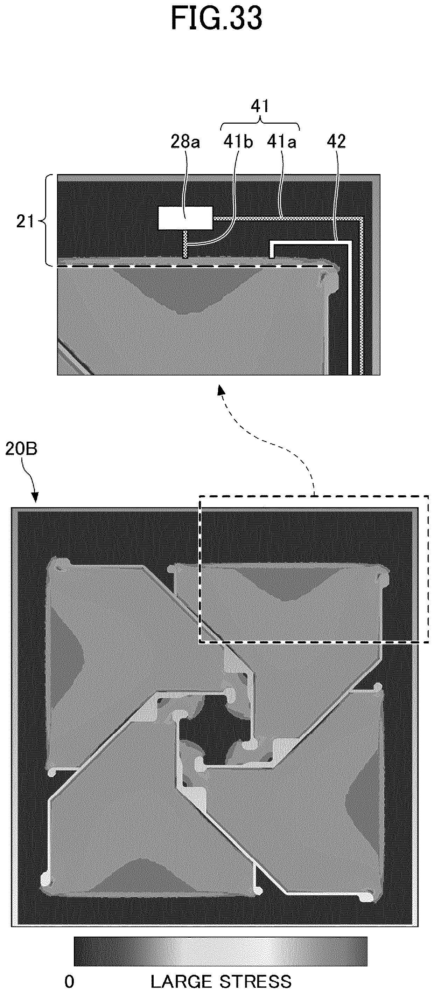

FIG. 33 is a simulation result of the stress distribution when moving the movable portion of the MEMS device. The lower portion of FIG. 33 shows the entire lower surface of the MEMS device 20B, and the upper portion is an enlarged view inside a lower dashed line. In an enlarged view, the conduction pad 28a, and portions of the first wiring 41 and the second wiring 42 are shown.

As shown in FIG. 33, a region where large stress is applied exists near the inner edge of the fixed portion 21. In this arrangement, it is preferable to arrange the first wiring 41 and the second wiring 42, so as to avoid the region where large stress is applied. Thus, when moving the movable portion 22 of the MEMS device 20B, the possibility of disconnection of the first wiring 41 and/or the second wiring 42 can be reduced.

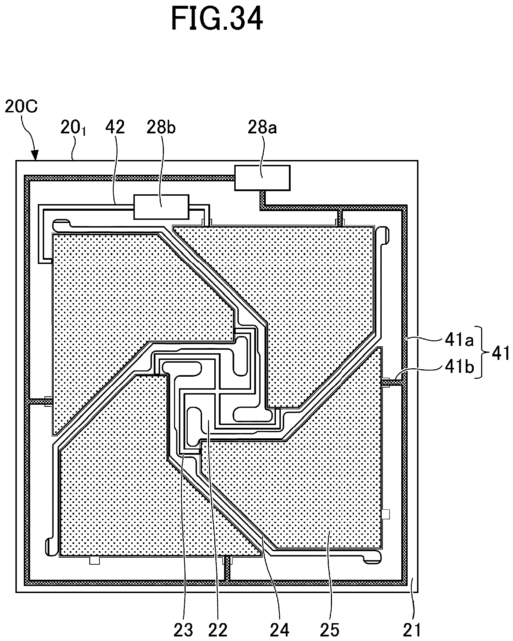

FIG. 34 is a lower view illustrating the wirings in the MEMS device in a first modification of the fifth embodiment. Referring to FIG. 34, a MEMS device 20C differs from the MEMS device 20B shown in FIG. 32 in the arrangement of the second wiring 42.

Specifically, in the example of FIG. 34, a portion of the second wiring 42 is arranged on the lower surface of the movable portion 22 and a plurality of torsion beams 23. In this arrangement, the path of the second wiring 42 that connects the conduction pad 28b to each drive source 25 can be shortened. Also, the routing path of the first wiring 41 that connects the conduction pad 28a to each drive source 25 can be short, similar to that shown in FIG. 32. Thus, it is possible to suppress the delay of signals input to the drive sources 25 that are far from the conduction pads 28a and 28b with respect to signals input to the drive sources 25 near the conduction pads 28a and 28b. As a result, similar to the case of FIG. 32, the displacement amount of the movable portion 22 can be increased, while improving the frequency characteristic of the MEMS device 20C.

### <Sixth Embodiment>

In a sixth embodiment, an example of facilitating inspection of displacement of the movable portion of the MEMS device is shown.

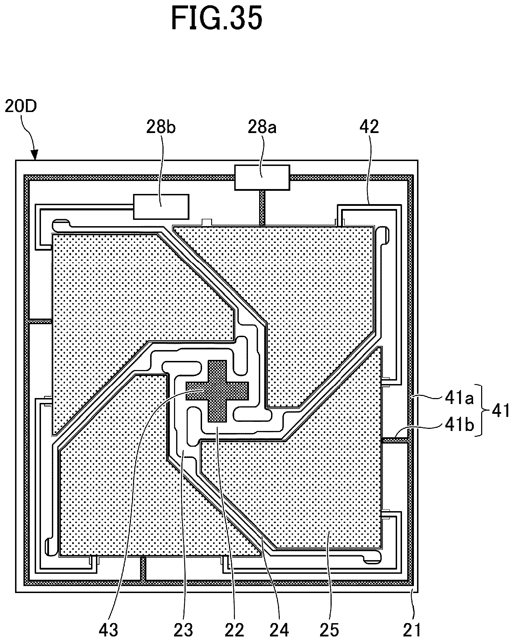

FIG. 35 is a lower view illustrating a metal film in the MEMS device according to the sixth embodiment. Referring to FIG. 35, in a MEMS device 20D, a cross-shaped metal film 43 is disposed on the lower surface of the movable portion 22.

Examples of materials of the metal film 43 include gold (Au), copper (Cu), silver (Ag), aluminum (Al), platinum (Pt), titanium (Ti), tungsten (W), and the like. The thickness of the metal film 43 can be, for example, approximately greater than or equal to 0.02 µm and less than or equal to 1.00 µm. The metal film 43 can be formed by, for example, sputtering. The visible light reflectance of the metal film 43 is 80% or more.

In order to simplify the manufacturing process, the metal film 43 is preferably formed of the same material as the material that is included in the first wiring 41 and the second wiring 42. For example, when the first wiring 41 and the second wiring 42 include gold, the metal film 43 is preferably formed of gold. Alternatively, the metal film 43 may be formed of the same material as a material included in an electrode constituting the drive source 25. For example, when the electrode that constitutes the drive source 25 includes platinum, the metal film 43 is preferably formed of platinum.

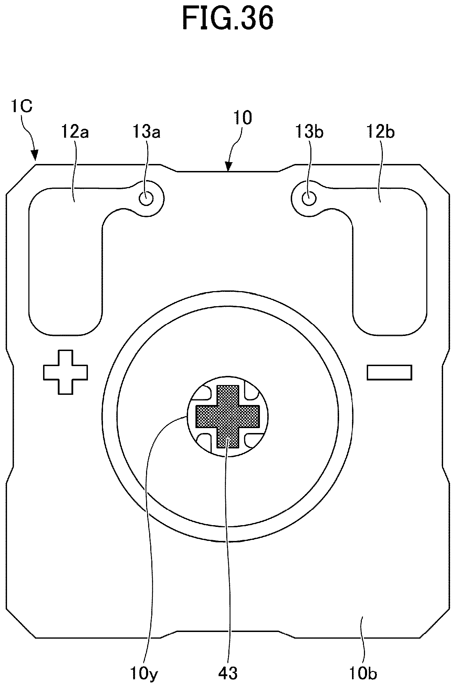

FIG. 36 is a lower view of an electro-acoustic transducer 1C using a MEMS device 20D. As described above, the substrate 10 has a through-hole 10y that serves as an air passage into and out of the substrate 10. In plan view, the metal film 43 overlaps the through-hole 10y. In this arrangement, light can be projected onto the metal film 43 from the outside of the electro-acoustic transducer 1C, and the reflected light from the metal film 43 can be received outside the electro-acoustic transducer 1C.

In this configuration, even after the MEMS device 20D is incorporated into the substrate 10, the displacement of the movable portion 22 can be measured using an optical displacement meter. Of course, even with the MEMS device 20D alone, the displacement of the movable portion 22 can be measured using an optical displacement meter. An optical displacement meter calculates the displacement of a measurement target by projecting light onto the measurement target and measuring an angle, position, and speed of the reflected light from the measurement target. An example of the optical displacement meter includes a laser displacement meter. The laser displacement meter uses, for example, a red laser with a wavelength of about 630 nm to 690 nm.

When the material of the movable portion 22 of the MEMS device 20D is silicon, the reflectance for the red laser in a wavelength band is about 35%. In this arrangement, if the metal film 43 is not provided on the lower surface of the movable portion 22, the laser displacement meter would not be used to measure the displacement of the movable portion 22, because an amount of reflected light is insufficient.

On the other hand, when the metal film 43 is provided on the lower surface of the movable portion 22, a reflectance of 80% or greater for a wavelength band of a red laser can be obtained. In this arrangement, by projecting light from the laser displacement meter onto the metal film 43, a sufficient amount of reflected light is obtained, and an S/N ratio is improved. As a result, the displacement of the movable portion 22 can be measured with high accuracy. In other words, the MEMS device 20D capable of measuring the displacement of the movable portion 22 with high accuracy can be realized.

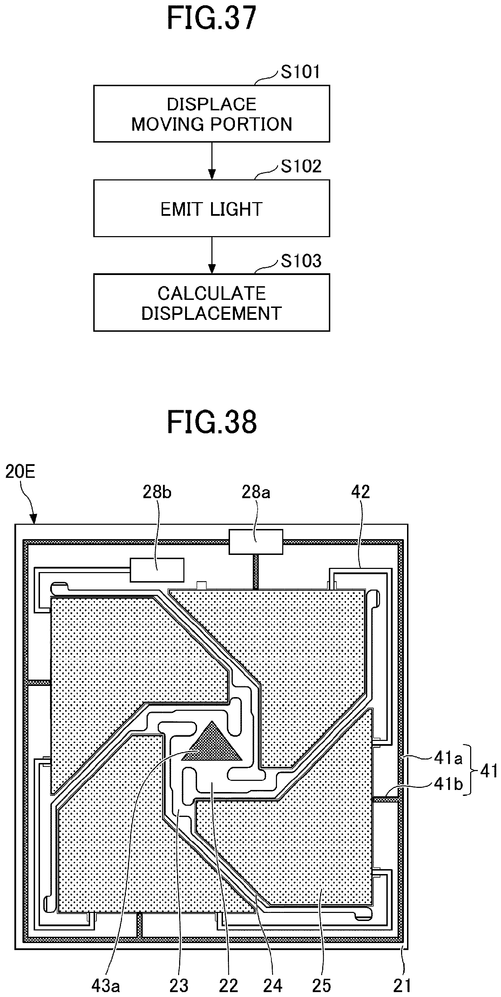

FIG. 37 is a measurement flow of the displacement of the movable portion. First, in step S101, the movable portion 22 is displaced. For example, the movable portion 22 can be repeatedly displaced at a constant frequency and a constant amplitude. Next, in step S102, light is projected onto the metal film 43 from a laser displacement meter or the like, and the reflected light from the metal film 43 is received by the laser displacement meter or the like. Next, in step S103, the displacement of the movable portion 22 is calculated based on the received reflected light.

In this arrangement, by arranging the metal film 43 on the lower surface of the movable portion 22, the displacement of the movable portion 22 can be measured with high accuracy. Instead of displacement measurement of the movable portion 22, sound pressure measurement or impedance measurement could also be considered. However, a special device is required for sound pressure measurement, resulting in higher inspection costs. In addition, although impedance measurement can be performed with a relatively inexpensive device, there is a disadvantage that the correlation with actual acoustic performance becomes low. On the other hand, the displacement of the movable portion 22 can be measured using a relatively inexpensive optical displacement meter, and the correlation with actual acoustic performance is sufficiently high.

In a structure in which a mesh 70 is provided to close the through-hole 10y of the substrate 10, the displacement of the movable portion 22 can be measured either before placing the mesh 70 or after removing the mesh 70.

The shape of the metal film that is formed on the lower surface of the movable portion 22 does not need to match the shape of the movable portion 22 as long as the metal film shape is larger than a beam diameter of the projected light. When the laser displacement meter is used, a beam diameter of the laser light is about 10 µm to 1000 um. Another example of the shape of the metal film provided in the movable portion 22 is shown below.

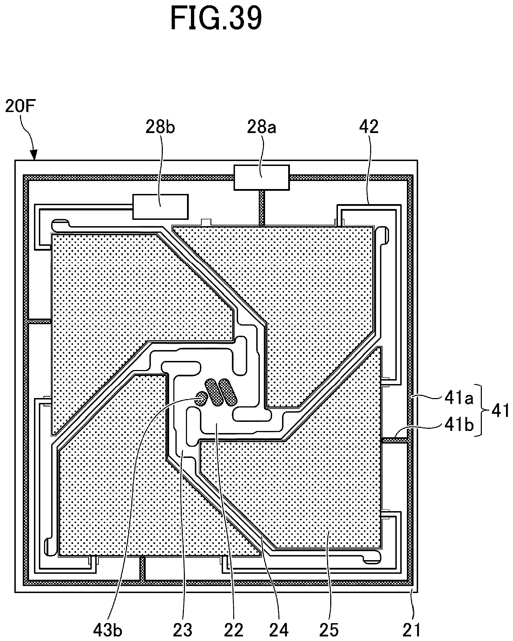

FIG. 38 is a lower view illustrating the metal film in the MEMS device in a first modification of the sixth embodiment. Referring to FIG. 38, in a MEMS device 20E, a triangular metal film 43a is disposed on the lower surface of the movable portion 22. FIG. 39 is a lower view illustrating the metal film in the MEMS device in a second modification of the sixth embodiment. Referring to FIG. 39, in a MEMS device 20F, a substantially mountain-shaped metal film 43b is disposed on the lower surface of the movable portion 22.

By arranging the metal film 43a or 43b on the lower surface of the movable portion 22, the displacement of the movable portion 22 can be measured with high accuracy, similar to the case where the metal film 43 is disposed. Furthermore, unlike the metal film 43, the metal films 43a and 43b are not point-symmetrical in shape. Specifically, the metal films 43a and 43b have shapes that narrow toward the conduction pads 28a and 28b. In this arrangement, the metal films 43a and 43b can be used to determine the orientation of MEMS devices 20E and 20F.

When assembling the MEMS devices 20E and 20F onto the substrate 10, it is necessary to align the MEMS devices 20E and 20F with the substrate 10 because the conduction pads 28a and 28b need to be joined with the internal connection pads 11a and 11b of the substrate 10. Since the orientation of the MEMS devices 20E and 20F can be easily determined by visually identifying the metal films 43a and 43b, it is possible to prevent misorientation errors while assembling the MEMS devices onto the substrate 10.

In the above description, an example of measuring the displacement of the movable portion 22 by providing a metal film on the lower surface of the movable portion 22 is shown. As another method, it is also possible to measure the displacement of the movable portion by projecting light from the membrane side of the electro-acoustic transducer shown in FIG. 12 and the like.

For example, in the electro-acoustic transducer 1 shown in FIG. 12, the vibrating plate 40 is exposed from the opening 50y of the lid member 50. In this arrangement, the displacement of the movable portion 22 can be calculated by projecting light from a laser displacement meter or the like onto the vibrating plate 40 and receiving the reflected light from the vibrating plate 40 by the laser displacement meter or the like. The central portion 32 of the membrane 30 and the vibrating plate 40 displace in the same manner as the movable portion 22, and in this case, if the displacement of the vibrating plate 40 is measured, it becomes the displacement of the movable portion 22.

When the vibrating plate 40 is formed of a material with low reflectivity such as a resin, it is necessary to arrange a metal film similar to the metal film 43 by vapor deposition or the like, at least in a region where light is projected on the upper surface of the vibrating plate 40, in order to improve the measurement accuracy. However, when the vibrating plate 40 is formed of a metal material, it is not necessary to arrange a metal film.

Also, when the vibrating plate 40 is not provided in the central portion 32 of the membrane 30, or when the vibrating plate 40 is provided on the lower surface side of the central portion 32 of the membrane 30, light is projected from a laser displacement meter or the like onto the central portion 32 of the membrane 30. Then, by receiving the reflected light from the central portion 32 of the membrane 30 by the laser displacement meter or the like, the displacement of the movable portion 22 can be calculated. The central portion 32 of the membrane 30 displaces in the same manner as the movable portion 22, and in this case, if the displacement of the central portion 32 of the membrane 30 is measured, it becomes the displacement of the movable portion 22.

When the membrane 30 is formed of a material with low reflectivity such as a resin, in order to improve the measurement accuracy, it is necessary to arrange a metal film similar to the metal film 43 by vapor deposition or the like, at least in a region where light is projected onto the upper surface of the central portion 32 of the membrane 30. However, when the membrane 30 is formed of a metal material, no metal film is necessary.

When measuring the displacement of the movable portion by projecting light from the membrane side of the electro-acoustic transducer, the position of the through-hole 10y of the substrate 10 becomes irrelevant to displacement measurement, and thus the through-hole 10y can be arranged at any position. In other words, a degree of design flexibility for arrangement of the through-hole 10y can be increased.

As described above, the method for measuring the displacement of a movable portion according to this embodiment includes a step of displacing the movable portion, a step of projecting light from the outside of an electro-acoustic transducer onto the movable portion or onto a portion that displaces in conjunction with a motion of the movable portion, and a step of calculating the displacement based on the reflected light of the projected light. Either a metal film is arranged at the position where light is projected, or a portion onto which light is projected is formed of a metal material. Thus, the displacement of the movable portion can be measured with high accuracy.

### (Seventh Embodiment)

In a seventh embodiment, an example of providing a membrane with an uneven structure is shown.

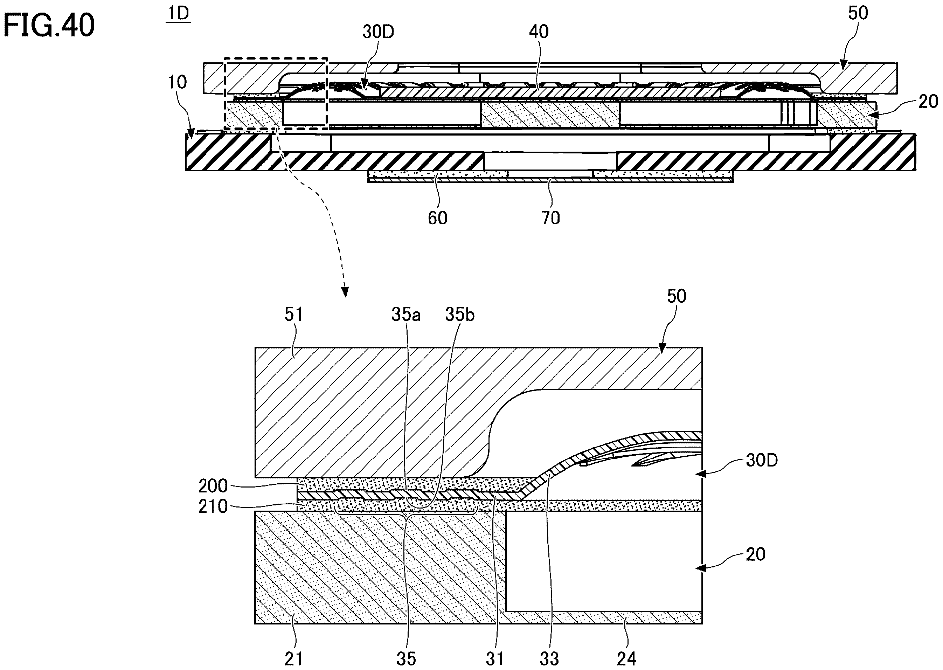

FIG. 40 is a cross-sectional view illustrating the electro-acoustic transducer according to the seventh embodiment. The upper part of FIG. 40 is an overall diagram of the electro-acoustic transducer, and the lower part is an enlarged view inside an upper dashed line.

As shown in FIG. 40, an electro-acoustic transducer 1D differs from the electro-acoustic transducer 1 (see FIG. 14 and the like) in that the electro-acoustic transducer 1D has a membrane 30D instead of the membrane 30.

The membrane 30D has a frame 31, a central portion 32, and a connection portion 33, and an uneven structure 35 is provided on the upper and lower surfaces of the frame 31. In the membrane 30D, the structure, material, and thickness of portions other than the uneven structure 35 may be the same as those of the membrane 30, for example.

The membrane 30D can be molded, for example, by heating and pressurizing a resin material using a mold. In this case, by providing an uneven structure on the surface of a mold used in advance, the uneven structure 35 can be formed simultaneously with portions such as the frame 31.

The uneven structure 35 includes, for example, a plurality of first protrusions 35a that protrude from the upper surface of the frame 31, and a plurality of first recesses 35b that are recessed from the lower surface of the frame 31 toward the upper surface, which is the opposite surface. In plan view, the first protrusion 35a and the first recess 35b are in overlapping positions. The height of the first protrusion 35a from the upper surface of the frame 31 is, for example, about 20 to 40 µm. The depth of the first recess 35b from the lower surface of the frame 31 is, for example, about 20 to 40 µm.

In plan view, at least a portion of the uneven structure 35 is positioned to overlap the upper surface of the fixed portion 21 of the MEMS device 20 and the lower surface of the thick plate portion 51 of the lid member 50. The upper side of the uneven structure 35 is bonded to a thick plate portion 51 of the lid member 50 via an adhesive layer 200. The lower side of the uneven structure 35 is bonded to the fixed portion 21 of the MEMS device 20 via an adhesive layer 210.

In this arrangement, by providing the uneven structure 35, an anchoring effect is generated, and as a result, it is possible to realize the membrane 30D that can improve adhesive strength to other components. Specifically, the adhesive strength between the frame 31 of the membrane 30D and the thick plate portion 51 of the lid member 50 can be improved, and the adhesive strength between the frame 31 of the membrane 30 and the fixed portion 21 of the MEMS device 20 can be improved.

The uneven structure 35 may include, for example, a plurality of first protrusions that protrude from the lower surface of the frame 31, and a plurality of first recesses that are recessed from the upper surface of the frame 31 toward the lower surface, which is the opposite surface. In other words, the uneven structure 35 shown in FIG. 40 may be inverted vertically. In this case, the same effect as described above can be achieved.

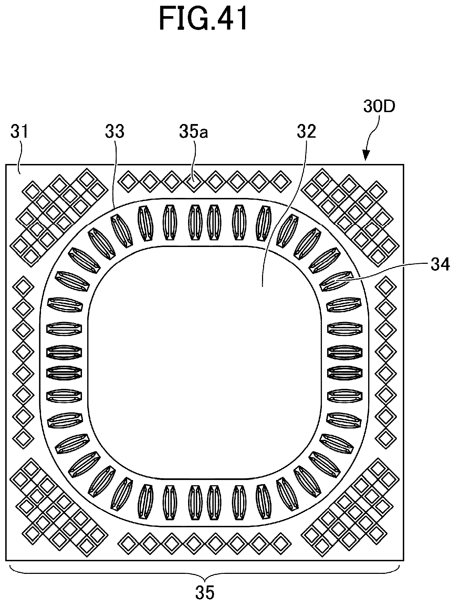

FIG. 41 is an upper view illustrating the membrane 30D. As shown in FIG. 41, the uneven structure 35 is preferably provided over the entire frame 31 of the membrane 30D. The shape of the first protrusion 35a and the first recess 35b in plan view may be rectangular or circular, or may be any other shape.

The shape of the first protrusion 35a and the first recess 35b in plan view may be point-symmetrical or non-symmetrical. Also, the shape of the first protrusion 35a and the first recess 35b in plan view are not limited to the dot shape as shown in FIG. 41, and may be, for example, linear or curved with a narrow width and long length, and these may be mixed together. The straight lines and curved lines may intersect in a grid pattern or the like.

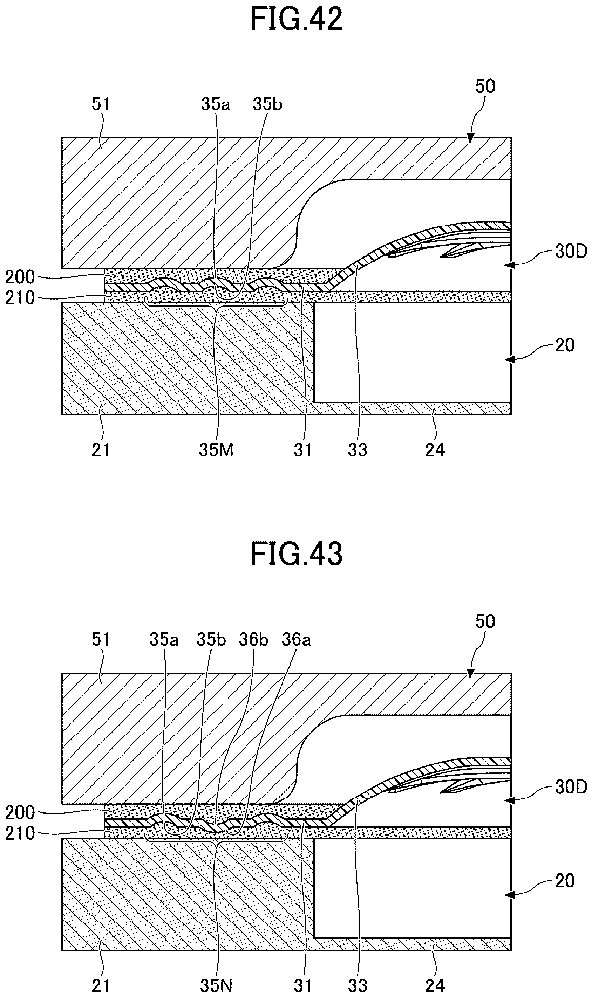

FIG. 42 is a partial cross-sectional view illustrating the electro-acoustic transducer in a first modification of the seventh embodiment. As shown in an uneven structure 35M shown in FIG. 42, the shape of the first protrusion 35a and the first recess 35b in a cross-sectional view may be curved, similar to a portion of a circle or an ellipse. In this case, since the uneven structure 35M provides an anchoring effect, the same effect as in the case of FIG. 40 is achieved.

FIG. 43 is a partial cross-sectional view illustrating the electro-acoustic transducer in a second modification of the seventh embodiment. The uneven structure 35N shown in FIG. 43 includes a plurality of first protrusions 35a that protrude from the upper surface of the frame 31, a plurality of second protrusions 36a that are recessed from the lower surface of the frame 31, a plurality of first recesses 35b that are recessed from the lower surface of the frame 31 toward the upper surface side, and a plurality of second recesses 36b that are recessed from the upper surface of the frame 31 toward the lower surface side. In plan view, the first protrusions 35a and the first recesses 35b overlap, and the second protrusions 36a and the second recesses 36b are in overlapping positions.

In this case, an anchoring effect is generated using the uneven structure 35N, and as a result, the same effect as in FIG. 40 is achieved. In a cross-sectional view, the shape of the first protrusions 35a, the first recesses 35b, the second protrusions 36a, and the second recesses 36b is not limited to the shape shown in FIG. 43, and a shape having corners such as a portion of the rectangle shown in FIG. 40 may be adopted. In this case, an anchoring effect is generated using the uneven structure 35N, and the same effect as in FIG. 40 is achieved.

Although the above-described preferred embodiments have been described in detail, the present disclosure is not limited to the embodiments, and various modifications and substitutions may be made to the embodiments without departing from the scope of the disclosure. Moreover, the contents described in one embodiment are applicable to other embodiments.

In the present disclosure, stress in the MEMS device can be reduced.

In the present disclosure, displacement of a movable portion can be increased in the MEMS device.

In the present disclosure, the MEMS device can be made compact.

In the present disclosure, in the MEMS device, a higher resonance frequency can be obtained.
The present disclosure includes the following clauses:
1. A micro electro mechanical systems (MEMS) device comprising:
   a frame-shaped fixed portion;
   a movable portion disposed inside the fixed portion in plan view;
   four torsion beams supporting the movable portion;
   a drive beam provided for each torsion beam of the four torsion beams, and including a first end connected to the torsion beam and a second end connected to an inner edge of the fixed portion; and
   a drive source disposed for each of the drive beams,
   wherein each of the drive beams is disposed point-symmetrically with respect to a center of the movable portion in plan view, and
   wherein, in plan view, each of the drive beams includes a region whose width in a direction parallel to a first side, of the drive beam, connected to the inner edge gradually increases toward the first side.
2. The MEMS device according to clause 1, wherein, in plan view, each of the drive beams has a maximum width in the direction parallel to the first side at a position of the first side.
3. The MEMS device according to clause 2, wherein, in plan view, each of the drive beams has a minimum width in the direction parallel to the first side at a position of a second side, of the drive beam, connected to the torsion beam.
4. The MEMS device according to any one of clauses 1 to 3, wherein in plan view, each of the drive beams includes a first trapezoidal first region and a second trapezoidal second region including a smaller area than the first region,
   wherein the first region is located on a side, of the drive beam, closer to the first side,
   wherein the second region is located on a side, of the drive beam, farther from the first side than the first region, and
   wherein, among trapezoids constituting the first region and the second region, when the side, of the drive beam, closer to the first side is defined as a lower base, and the side, of the drive beam, farther from the first side is defined as an upper base, a length of the lower base of the trapezoid constituting the second region is equal to or less than a length of the upper base of the trapezoid constituting the first region.
5. The MEMS device according to clause 4, wherein in plan view, the first side, the upper base of the trapezoid constituting the first region, and the upper base of the trapezoid constituting the second region are parallel to one another.
6. The MEMS device according to clause 4, wherein in plan view, a first lateral side of the trapezoid constituting the first region and a first lateral side of the trapezoid constituting the second region are perpendicular to the first side.
7. The MEMS device according to clause 6, wherein in plan view, a second lateral side of the trapezoid constituting the first region and a second lateral side of the trapezoid constituting the second region have different inclination directions with respect to the first side.
8. The MEMS device according to clause 6, wherein in plan view, the first lateral side or the second lateral side of the trapezoid constituting the second region is connected to the torsion beam.
9. The MEMS device according to clause 4, further comprising:
   a rectangular third region between the first side and the first region in plan view; and
   a trapezoidal fourth region between the first region and the second region in the plan view.
10. A micro electro mechanical systems (MEMS) device comprising:
   a rectangular frame-shaped fixed portion;
   a movable portion disposed inside the fixed portion in plan view;
   four torsion beams supporting the movable portion;
   a drive beam provided for each torsion beam of the torsion beams, and including a first end connected to the torsion beam and a second end connected to an inner edge of the fixed portion; and
   a drive source disposed for each of drive beams,
   wherein the drive beams are formed of single-crystal silicon, and
   wherein all inner edges and outer edges of the fixed portion are parallel to [100] crystal orientation of the single-crystal silicon.
11. The MEMS device according to clause 10, wherein the fixed portion, the movable portion, and the torsion beams are formed of the single-crystal silicon.
12. The MEMS device according to clause 10, wherein the fixed portion and the movable portion are formed of a support layer, a buried layer, and an active layer that constitute an SOI substrate, and
   wherein the torsion beams are formed of the active layer in the SOI substrate.
13. An electro-acoustic transducer comprising:
   a substrate;
   the MEMS device of any one of clauses 1 to 3 and 10 to 12 disposed on the substrate; and
   a membrane disposed on the MEMS device and bonded to the movable portion.
14. A micro electro mechanical systems (MEMS) device comprising:
   a frame-shaped fixed portion;
   a movable portion disposed inside the fixed portion in plan view;
   a plurality of torsion beams supporting the movable portion;
   a drive beam provided for each torsion beam of the plurality of torsion beams, and including a first end connected to the torsion beam and a second end connected to an inner edge of the fixed portion; and
   a drive source disposed for each drive beam,
   wherein in plan view, the movable portion includes a same number of extending portions as the plurality of torsion beams, each of the extending portions extending radially from a center of the movable portion,
   wherein each of the extending portions includes an upper surface, a lower surface, an end surface, and two side surfaces connected to the end surface, and
   wherein each torsion beam is connected to both of adjacent side surfaces included in different extending portions among the extending portions.
15. The MEMS device according to clause 14, wherein in plan view, each torsion beam is connected to an entire portion of a first side surface and to a part of a second side surface, among the adjacent side surfaces.
16. The MEMS device according to clause 15, wherein in plan view, for each of the plurality of torsion beams, a corner of a portion connected to the second side surface among the adjacent side surfaces is rounded.
17. The MEMS device according to clause 14, wherein in plan view, each torsion beam includes an L-shaped region.
18. The MEMS device according to clause 14, wherein in plan view, the movable portion has a cross shape that is point-symmetrical about a center of the movable portion.
19. The MEMS device according to any one of clauses 14 to 18, further comprising:
   a protrusion that protrudes, in plan view, from each side of an inner surface of the fixed portion toward the movable portion, the protrusion having a same thickness as the fixed portion,
   wherein each of the drive beams is connected to both the inner surface of the fixed portion and a side surface of the protrusion that is continuous with the inner surface of the fixed portion.
20. The MEMS device according to clause 19, wherein in plan view, for each of the drive beams, a corner of a portion connected to the side surface of the protrusion is rounded.
21. The MEMS device according to any one of clauses 14 to 18, further comprising:
   a recess that is recessed from each side of an inner surface of the fixed portion toward an outer surface,
   wherein each of the drive beams is connected to both an inner surface of the fixed portion and an inner surface of the recess that is continuous with the inner surface of the fixed portion.
22. The MEMS device according to clause 21, wherein in plan view, for each of the drive beams, a corner of a portion connected to the inner surface of the recess is rounded.
23. An electro-acoustic transducer comprising:
   a substrate;
   the MEMS device of any one of clauses 14 to 18 disposed on the substrate; and
   a membrane disposed on the MEMS device and bonded to the movable portion.
24. A micro electro mechanical systems (MEMS) device comprising:
   a frame-shaped fixed portion;
   a movable portion disposed inside the fixed portion in plan view;
   torsion beams and drive beams, each of the torsion beams and the drive beams connecting the fixed portion and the movable portion at a position closer to a lower surface of a corresponding beam among the torsion beams and the drive beams than an upper surface of the corresponding beam;
   a drive source disposed on the lower surface of each of the drive beams;
   a pair of conduction pads disposed on a lower surface of the fixed portion;
   a first wiring that electrically connects a first conduction pad in the pair of conduction pads to a first electrode of each of the drive sources; and
   a second wiring that electrically connects a second conduction pad in the pair of conduction pads to a second electrode of each of the drive sources,
   wherein the first wiring includes:
      a loop wiring that extends from the first conduction pad is disposed in a loop shape to surround the drive sources in plan view, and that returns to the first conduction pad, and
      a branch wiring that branches from the loop wiring and connects to each of the drive sources, and
   wherein the second wiring is disposed inside the loop wiring in plan view.
25. The MEMS device according to clause 24, wherein the second wiring extends from the second conduction pad, passes through the drive sources, and returns to the second conduction pad.
26. The MEMS device according to clause 25, wherein the second wiring includes a portion that directly connects adjacent drive sources.
27. The MEMS device according to clause 26, wherein the portion of the second wiring is disposed along a portion of the loop wiring that connects adjacent branch wirings.
28. The MEMS device according to clause 24, wherein a portion of the second wiring is disposed on a lower surface of the movable portion and lower surfaces of the torsion beams.
29. The MEMS device according to clause 24, wherein the first wiring is a wiring to be connected to a ground wiring on an external circuit, and the second wiring is a wiring to be connected to a signal wiring on the external circuit.
30. The MEMS device according to clause 24, wherein in plan view, the fixed portion has a rectangular frame shape,
   wherein, in the fixed portion, a portion along a first side is wider than portions along three other sides, and
   wherein the pair of conduction pads is disposed on the portion of the fixed portion along the first side.
31. An electro-acoustic transducer comprising:
   a substrate;
   the MEMS device of clause 24 disposed on the substrate; and
   a membrane disposed on the MEMS device and bonded to the movable portion.
32. A micro electro mechanical systems (MEMS) device comprising:
   a frame-shaped fixed portion;
   a movable portion disposed inside the fixed portion in plan view;
   four torsion beams supporting the movable portion;
   a drive beam provided for each torsion beam of the torsion beams, and including a first end connected to the torsion beam and a second end connected to an inner surface of the fixed portion; and
   a drive source disposed on each of drive beams,
   wherein the movable portion has a cross shape.
33. The MEMS device according to clause 32, wherein the movable portion is point-symmetrical about a center of the movable portion in plan view.
34. The MEMS device according to clause 32, wherein in plan view, each of the torsion beams includes an L-shaped region.
35. The MEMS device according to clause 34, wherein each of the torsion beams is point-symmetrical about a center of the movable portion in plan view.
36. The MEMS device according to clause 32, wherein each of the drive beams is point-symmetrical about a center of the movable portion in plan view.
37. An electro-acoustic transducer comprising:
   a substrate;
   the MEMS device of any one of clauses 32 to 36 disposed on the substrate; and
   a membrane disposed on the MEMS device and connected to the movable portion.
38. The electro-acoustic transducer according to clause 37, wherein in plan view, the membrane includes:
   a frame including a circular inner edge,
   a circular central portion located inside the circular inner edge of the frame, and
   a connection portion connecting the circular inner edge of the frame and an outer edge of the circular central portion, and
   wherein the circular central portion is connected to the movable portion.
39. The electro-acoustic transducer according to clause 38, wherein the connection portion protrudes above an upper surface of the circular central portion, and
   wherein in a cross-sectional view taken in a direction perpendicular to the upper surface of the circular central portion, the upper surface and a lower surface of the connection portion are curved in a same direction.
40. The electro-acoustic transducer according to clause 39, wherein the connection portion includes a plurality of slits arranged at predetermined intervals.
41. The electro-acoustic transducer according to clause 38, wherein the frame, the circular central portion, and the connection portion have an integral structure.
42. The electro-acoustic transducer according to clause 38, further comprising:
   a vibrating plate fixed to the circular central portion.
43. The electro-acoustic transducer according to clause 38, further comprising:
   a cover member disposed on the membrane, and including:
      a frame-shaped thick plate portion, and
      a thin plate portion that is thinner than the frame-shaped thick plate portion, the thin plate portion being disposed inside the thick plate portion and having an opening,
   wherein a lower surface of the thick plate portion is bonded to an upper surface of the the frame.
44. The electro-acoustic transducer according to clause 38, further comprising:
   a pair of internal connection pads that serves as a path for a signal supplied to the drive source, the pair of internal connection pads being disposed on an upper surface of the substrate; and
   a pair of external connection pads disposed on a lower surface of the substrate,
   wherein each internal connection pad and a corresponding external connection pad are electrically connected via a through-wiring that penetrates the substrate from the upper surface to the lower surface of the substrate.

## Claims

1. A micro electro mechanical systems (MEMS) device comprising:
a frame-shaped fixed portion;
a movable portion disposed inside the fixed portion in plan view;
four torsion beams supporting the movable portion;
a drive beam provided for each torsion beam of the four torsion beams, and including a first end connected to the torsion beam and a second end connected to an inner edge of the fixed portion; and
a drive source disposed for each of the drive beams,
wherein each of the drive beams is disposed point-symmetrically with respect to a center of the movable portion in plan view, and
wherein, in plan view, each of the drive beams includes a region whose width in a direction parallel to a first side, of the drive beam, connected to the inner edge gradually increases toward the first side.

2. The MEMS device according to claim 1, wherein, in plan view, each of the drive beams has a maximum width in the direction parallel to the first side at a position of the first side.

3. The MEMS device according to claim 2, wherein, in plan view, each of the drive beams has a minimum width in the direction parallel to the first side at a position of a second side, of the drive beam, connected to the torsion beam.

4. The MEMS device according to any one of claims 1 to 3, wherein in plan view, each of the drive beams includes a first trapezoidal first region and a second trapezoidal second region including a smaller area than the first region,
wherein the first region is located on a side, of the drive beam, closer to the first side,
wherein the second region is located on a side, of the drive beam, farther from the first side than the first region, and
wherein, among trapezoids constituting the first region and the second region, when the side, of the drive beam, closer to the first side is defined as a lower base, and the side, of the drive beam, farther from the first side is defined as an upper base, a length of the lower base of the trapezoid constituting the second region is equal to or less than a length of the upper base of the trapezoid constituting the first region.

5. The MEMS device according to claim 4, wherein in plan view, the first side, the upper base of the trapezoid constituting the first region, and the upper base of the trapezoid constituting the second region are parallel to one another.

6. The MEMS device according to claim 4, wherein in plan view, a first lateral side of the trapezoid constituting the first region and a first lateral side of the trapezoid constituting the second region are perpendicular to the first side.

7. The MEMS device according to claim 6, wherein in plan view, a second lateral side of the trapezoid constituting the first region and a second lateral side of the trapezoid constituting the second region have different inclination directions with respect to the first side.

8. The MEMS device according to claim 6, wherein in plan view, the first lateral side or the second lateral side of the trapezoid constituting the second region is connected to the torsion beam.

9. The MEMS device according to claim 4, further comprising:
a rectangular third region between the first side and the first region in plan view; and
a trapezoidal fourth region between the first region and the second region in the plan view.

10. A micro electro mechanical systems (MEMS) device comprising:
a rectangular frame-shaped fixed portion;
a movable portion disposed inside the fixed portion in plan view;
four torsion beams supporting the movable portion;
a drive beam provided for each torsion beam of the torsion beams, and including a first end connected to the torsion beam and a second end connected to an inner edge of the fixed portion; and
a drive source disposed for each of drive beams,
wherein the drive beams are formed of single-crystal silicon, and
wherein all inner edges and outer edges of the fixed portion are parallel to [100] crystal orientation of the single-crystal silicon.

11. The MEMS device according to claim 10, wherein the fixed portion, the movable portion, and the torsion beams are formed of the single-crystal silicon.

12. The MEMS device according to claim 10, wherein the fixed portion and the movable portion are formed of a support layer, a buried layer, and an active layer that constitute an SOI substrate, and
wherein the torsion beams are formed of the active layer in the SOI substrate.

13. An electro-acoustic transducer comprising:
a substrate;
the MEMS device of any one of claims 1 to 3 and 10 to 12 disposed on the substrate; and
a membrane disposed on the MEMS device and bonded to the movable portion.
